# EUROPEAN PATENT APPLICATION

(11) **EP 1 956 660 A1**
(43) Date of publication of application: **13.08.2008**
(21) Application number: 06833548.8
(22) Date of filing: 28.11.2006
(51) Int. Cl.: H01L 31/042

(54) **BACK-PROTECTIVE SHEET FOR SOLAR CELL MODULE, BACK LAMINATE FOR SOLAR CELL MODULE, AND SOLAR CELL MODULE**

(30) Priority: 29.11.2005 JP 2005344245
(71) Applicant: Dai Nippon Printing Co., Ltd., Tokyo 162-8001 (JP); Sanyo Electric Co., Ltd., Moriguchi City, Osaka 570-8677 (JP)
(72) Inventor: TSUZUKI, Atsuo, Tokyo 162-8001 (JP); HAYASHI, Katsuhiko, Tokyo 162-8001 (JP); OOI, Kasumi, Tokyo 162-8001 (JP); MARUYAMA, Eiji, Moriguchi-shi, Osaka 570-8677 (JP); YOSHIMINE, Yukihiro, Moriguchi-shi, Osaka 570-8677 (JP); TSUNOMURA,Yasufumi, Moriguchi-shi, Osaka 570-8677 (JP)
(74) Representative: Smart, Peter John
(86) International application number: PCT/JP2006/323744
(87) International publication number: WO 2007/063860

(57) **Abstract**

A main object of the present invention is to provide a backsheet for photovoltaic module superior in hydrolysis resistance and thus in durability. To attain the object, the present invention provides a backsheet for photovoltaic module comprising a hydrolysis-resistant film and a resin film laminated on the hydrolysis-resistant film, **characterized in that** the hydrolysis-resistant film is made of a polyester resin having a carboxy end-group content of 15 equivalent/ton or less, and the resin film is made of a polypropylene resin.

## Description

### TECHNICAL FIELD

The present invention relates to a backsheet for photovoltaic module used in a photovoltaic module, more specifically to a backsheet for a photovoltaic module superior in hydrolysis resistance and thus in durability.

### BACKGROUND ART

In recent years, attention has been paid to a photovoltaic as a clean energy source in light of the increasing awareness of environmental issues. Generally, the photovoltaic module for the photovoltaic have a configuration including a frontside transparent substrate, an encapsulant, photovoltaic devices, an encapsulant and a backsheet that are laminated in this order and have a function to generate power by irradiation of sunlight into the photovoltaic device.

The photovoltaic cells are mainly used outdoor because of the characteristics described above, and thus, high durability is demanded for the members constituting the photovoltaic modules. In particular, the backsheet used in such a photovoltaic module should be superior in mechanical strength and also in durability such as hydrolysis resistance, mainly for protection of the rear face of the photovoltaic module. Currently, for example, plastic base materials superior in strength are used most frequently for such a backsheet for photovoltaic module, and metal plates and others are also used. In particular, composite films of a fluorine resin film and a metal foil are used widely (Patent Document 1).

However, such a composite film of a fluorine resin film and a metal foil has possibility of short circuiting, if dents or scratches are formed thereon by external force, and thus, there exists a demand for further improvement of the material for use as a backsheet for photovoltaic module. In addition, use of a metal foil raises a concern about short circuiting, the main requirement for photovoltaic modules, when used as a casing material for electronic devices such as photovoltaic module that may be exposed to a relatively high voltage, and thus, the short-circuiting resistance thereof is still left to be improved. Further, the fluorine resin film, which has a concern regarding its possible high load on environment depending on the discharge or processing method, would not be optimal as the part for the photovoltaic module that claims to be a clean energy source.

Under the circumstances above, Patent Document 2 discloses a backsheet for photovoltaic module comprising a hydrolysis-resistant resin film, and a resin film laminate in which a two or three layers of metal oxide-coated resin film and a white resin film are laminated. The backsheet for photovoltaic module in such a configuration is advantageous in that the problem in short-circuiting resistance, one of the most important problems associated with conventional backsheets for photovoltaic modules, is overcome. On the other hand, as for the durability thereof, there remained a problem of low hydrolysis resistance even if a hydrolysis-resistant resin film was used, because a polyester resin lower in hydrolysis resistance is used as the white resin film.

Patent Document 1: Japanese Patent Application Publication No. 2000-174296
Patent Document 2: Japanese Patent Application Publication No. 2002-100788

### DISCLOSURE OF THE INVENTION

### PROBLEMS TO BE SOLVED BY THE INVENTION

A main object of the present invention, which was made to solve the problems above, is to provide a backsheet for photovoltaic module superior in hydrolysis resistance and thus in durability.

### MEANS FOR SOLVING THE PROBLEMS

To attain the object, the present invention provides a backsheet for photovoltaic module comprising a hydrolysis-resistant film and a resin film laminated on the hydrolysis-resistant film, characterized in that the hydrolysis-resistant film is made of a polyester resin having a carboxy end-group content of 15 equivalent/ton or less, and the resin film is made of a polypropylene resin.

According to the present invention, because the polypropylene resin above is superior in hydrolysis resistance, it is possible to obtain a backsheet for photovoltaic module higher in durability, by synergic effect of using a polyester resin having a carboxy end-group content of 15 equivalent/ton or less as the hydrolysis-resistant film and of laminating a resin film of a polypropylene resin on the hydrolysis-resistant film.
Also according to the present invention, because the polypropylene resin is thermally adhesive, it is possible to obtain a backsheet for photovoltaic module superior in adhesiveness to other members used in photovoltaic module such as an encapsulant for photovoltaic module layer and a gas barrier film.

In the invention, between the hydrolysis-resistant film and the resin film, it is preferable to form a gas barrier film having a base film and a gas-barrier layer formed on at least one side of the base film. The backsheet for photovoltaic module of the invention may further comprise two or more of the gas barrier films.
It is because presence of the gas barrier film between the hydrolysis-resistant film and resin film is effective in improving the moisture barrier characteristics of the backsheet for photovoltaic module according to the present invention, it is possible to improve the hydrolysis resistance of the backsheet for photovoltaic module according to the present invention, and further possible to improve the durability of the photovoltaic module employing the backsheet for photovoltaic module of the present invention.

Also in the present invention, an intrinsic viscosity of the polyester resin is preferably 0.8 dl/g or more. This is because it is possible to improve the toughness, rigidity and heat resistance of the backsheet for photovoltaic module of the present invention, by using the polyester resin having an intrinsic viscosity of 0.8 dl/g or more.

The present invention further provides a backsheet for photovoltaic module, which comprises: a first hydrolysis-resistant film, a first gas barrier film having a first base film and a first gas-barrier layer formed thereon, a resin film, a second gas barrier film having a second base film and a second gas-barrier layer formed thereon, and a second hydrolysis-resistant film that are laminated in this order, characterized in that at least one of the first hydrolysis-resistant film and the second hydrolysis-resistant film is made of a polyester resin having a carboxy end-group content of 15 equivalent/ton or less, and the resin film is made of a polypropylene resin.

According to the present invention, it is possible to obtain a back sheet for photovoltaic module superior in hydrolysis resistance, by using a polyester resin having a carboxy end-group content of 15 equivalent/ton or less for at least one of the first and the second hydrolysis-resistant films and also using a polypropylene resin superior in hydrolysis resistance for the resin film. It is also possible to obtain a backsheet for photovoltaic module more superior in moisture barrier characteristics, by forming two gas barrier films, i.e., the first and the second gas barrier films.

Also in the present invention, an intrinsic viscosity of the polyester resin is preferably 0.8 dl/g or more. This is because it is possible to improve the toughness, rigidity and heat resistance of the backsheet for photovoltaic module of the present invention, by using the polyester resin having an intrinsic viscosity of 0.8 dl/g or more.

The heat shrinkage rate at 150°C for 30 minutes of the backsheet for photovoltaic module in the present invention is preferably 1.0% or less. It is because, when the heat shrinkage rate is in the range above, it is possible to prevent deformation caused by heat shrinkage during production of a photovoltaic module using the backsheet for photovoltaic module of the present invention, and thus, to produce a photovoltaic module with the backsheet for photovoltaic module of the present invention at high productivity.

The present invention further provides a back side laminate for photovoltaic module, comprising the backsheet for photovoltaic module and an encapsulant for photovoltaic module laminated on the resin film of the backsheet for photovoltaic module.

According to the present invention, it is possible to obtain a backside laminate for photovoltaic module superior in hydrolysis resistance, by using the backsheet for photovoltaic module of the present invention.

In the present invention, the encapsulant for photovoltaic module preferably contains a copolymer of a polyolefin compound and an ethylenically unsaturatedsilane compound. Itisbecause the copolymer of a polyolefin compound and an ethylenically unsaturated silane compound is superior in adhesiveness to the polypropylene resin constituting the resin film.

The present invention also provides a photovoltaic module comprising a photovoltaic device, a front encapsulant layer and a backside encapsulant layer sandwiching the photovoltaic device, a frontside transparent substrate laminated on the front encapsulant layer, and a backsheet laminated on the backside encapsulant layer, characterized in that the backsheet is the backsheet for photovoltaic module.

According to the present invention, it is possible to obtain a photovoltaic module superior in durability, by using the backsheet for photovoltaic module mentioned above as the backsheet for photovoltaic module.

In the present invention, a terminal box is preferably installed on the backsheet. It is because the terminal box installed makes the photovoltaic module according to the present invention more favorable in practical performance.

Further in the present invention, the terminal box is preferably bonded to the hydrolysis-resistant film constituting the backsheet with a silicone-based adhesive agent. The terminal box can be bonded more tightly, when it is bonded onto the hydrolysis-resistant film with a silicone-based adhesive agent.

### EFFECT OF THE INVENTION

The present invention advantageously provides a backsheet for photovoltaic module superior in hydrolysis resistance and thus in durability.

### BRIEF DESCRIPTION OF THE DRAWING

FIG. 1 is a schematic view illustrating an example of the backsheet for photovoltaic module according to the present invention.
FIG. 2 is a schematic view illustrating another example of the backsheet for photovoltaic module according to the present invention.
FIG. 3 is a schematic view illustrating another example of the backsheet for photovoltaic module according to the present invention.
FIG. 4 is a schematic view illustrating yet another example of the backsheet for photovoltaic module according to the present invention.
FIG. 5 is a schematic view illustrating still another example of the backsheet for photovoltaic module according to the present invention.
FIGS. 6A and 6B are each a schematic view illustrating an example of the backside laminate for photovoltaic module according to the present invention.
FIG. 7 is a schematic cross-sectional view showing one example of a photovoltaic module according to the present invention.

### EXPLANATION OF REFERENCE NUMERALS

1, 21a, 21b: Hydrolysis-resistant film
2, 22: Resin film
3, 23a, 23b: Base film
4, 24a, 24b: Gas-barrier layer
5, 25a, 25b: Gas barrier film
10, 11, 12, 13, 14: Backsheet for photovoltaic module
31, 32: Backside laminate for photovoltaic module
41: Encapsulant for photovoltaic module
51: Photovoltaic device
52a: Front encapsulant layer
52b: Backside encapsulant layer
53: Frontside transparent substrate
54: Wiring
55: Terminal box
56: Adhesive agent
57: Metal frame
60: Photovoltaic module

### BEST MODE FOR CARRYING OUT THE INVENTION

Hereinafter, the backsheet for photovoltaic module, the backside laminate for photovoltaic module, and the photovoltaic module according to the present invention will be described.

### A. Backsheet for photovoltaic module

First, the backsheet for photovoltaic module of the present invention will be described. The backsheet for photovoltaic module according to the present invention has two embodiments, of its configuration. Hereinafter, the backsheet for photovoltaic module of the present invention in each embodiment will be described separately in detail.

### A-1. Backsheet for photovoltaic module in first embodiment

First, a backsheet for photovoltaic module in the first embodiment will be explained. The backsheet for photovoltaic module of the present embodiment comprises a hydrolysis-resistant film and a resin film laminated on the hydrolysis-resistant film, characterized in that the hydrolysis-resistant film is made of a polyester resin having a carboxy end-group content of 15 equivalent/ton or less, and the resin film is made of a polypropylene resin.

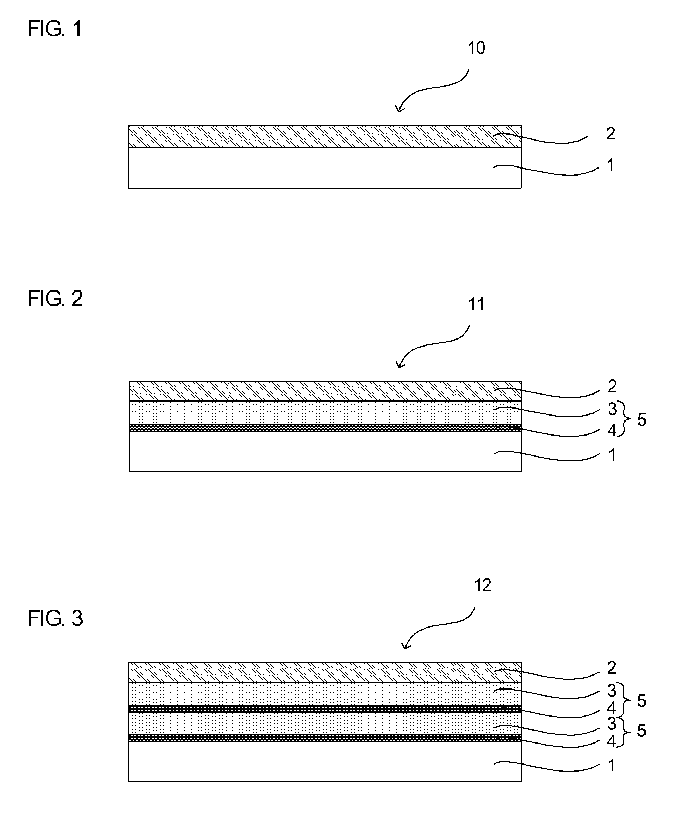

Hereinafter, the backsheet for photovoltaic module in the present embodiment will be described with reference to drawings. FIG. 1 is a schematic sectional view illustrating an example of the backsheet for photovoltaic module in the present embodiment. As exemplified in FIG. 1, the backsheet 10 for photovoltaic module in the present embodiment has a configuration comprising a hydrolysis-resistant film 1 and a resin film 2 laminated thereon.
The backsheet 10 for photovoltaic module in the present embodiment characteristically has the hydrolysis-resistant film 1 of a polyester resin having a carboxy end-group content of 15 equivalent/ton or less and the resin film 2 of a polypropylene resin.

The backsheet for photovoltaic module in the present embodiment may have a configuration other than that comprising the hydrolysis-resistant film and the resin film. FIG. 2 is a schematic sectional view illustrating another configuration having a gas barrier film in addition to the hydrolysis-resistant film and the resin film. As exemplified in FIG. 2, the backsheet 11 for photovoltaic module in the present embodiment may have a gas barrier film 5 between a hydrolysis-resistant film 1 and a resin film 2. The gas barrier film 5 used in the present embodiment normally has a base film 3 and a gas-barrier layer 4 formed on the base film.

The backsheet for photovoltaic module according to the present embodiment, wherein the polyester resin for the hydrolysis-resistant film has a carboxy end-group content of 15 equivalent/ton or less, can restrain the progress in hydrolysis reaction of the polyester resin even in high-temperature and high-humidity atmosphere. In addition, the polypropylene resin for the resin film, which has no hydrolytic functional group, is superior in hydrolysis resistance. Therefore, the backsheet for photovoltaic module in the present embodiment having a laminated configuration comprising the hydrolysis-resistant film and the resin film is superior in hydrolysis resistance as a whole, and thus, according to the present embodiment, it is possible to obtain a backsheet for photovoltaic module superior in hydrolysis resistance and thus in durability.

In addition, the backsheet for photovoltaic module in the present embodiment has a resin film of a polypropylene resin as the outmost layer. Because the polypropylene resin is thermally adhesive, the backsheet for photovoltaic module in the present embodiment is characteristically superior in adhesiveness, for example, to other members used in the photovoltaic module such as an encapsulant for photovoltaic module.

The backsheet for photovoltaic module in the present embodiment comprises a hydrolysis-resistant film and a resin film. Hereinafter, each component for the backsheet for photovoltaic module in the present embodiment will be described in detail.

### 1. Resin film

First, the resin film for the backsheet for photovoltaic module in the present embodiment will be described. The resin film used in the present embodiment contains a polypropylene resin and is characteristically superior in hydrolysis resistance.

### (1) Polypropylene resin

The polypropylene resin for the resin film used in the present embodiment will be described. The polypropylene resin used in the present embodiment is not particularly limited, if it has properties, such as hydrolysis resistance, weather resistance, heat resistance and light resistance, suitable for the use environment of the photovoltaic modules employing the backsheet for photovoltaic module in the present embodiment and is superior in the temporal stability of the properties above.
Examples of the polypropylene resins include isotactic polypropylene resins (homo polypropylene, random polypropylene, and block polypropylene), syndiotactic polypropylene resins, and atactic polypropylene resins.
In the present embodiment, a mixture of two or more polypropylene resins may also be used as the polypropylene resin.

Among the polypropylene resins in the present embodiment, use of an isotactic polypropylene resin is preferable. This is because it is possible to produce a backsheet for photovoltaic module applicable to a wide range of use environment easily, by using the isotactic polypropylene resin.

The polypropylene resin is not particularly limited, if it contains a polymer prepared by polymerization of propylene. Examples of the polypropylene resins include propylene homopolymers, copolymers of propylene with other olefinic resins, a mixture of a propylene homopolymer with other resins, copolymers of propylene with other olefinic resins, and mixtures thereof with other resins. Particularly in the present embodiment, the polypropylene resin for use is preferably a mixture of the propylene homopolymer with other resins. This is because it is possible by using such a mixture to modify the various physical properties of the resin film, for example, according to the environment where the backsheet for photovoltaic module in the present embodiment is used.

The propylene homopolymer is not particularly limited, if it is a polymer prepared by polymerization of propylene monomer. Examples of the propylene homopolymers include low-molecular weight polypropylenes obtained by polymerization of propylene monomer for example by using a cationic polymerization catalyst, and high-molecular weight and highly crystalline isotactic polymers obtained by polymerization of propylene monomer by using a Ziegler Natta catalyst. The isotactic polymers normally have a melting point of 164°C to 170°C and a specific density of approximately 0.90 to 0.91. Because it has a molecular weight of approximately 100,000 to 200,000, it is also superior in tensile strength and impact strength and further, in heat resistance and flexing fatigue resistance, while also favorable in processability. Because of the properties above, use of the isotactic polymer is favorable in the present embodiment.

The other resin is not particularly limited, if it is a resin compatible with the propylene homopolymer. The other resin for use in the present embodiment is, for example, a polyethylene resin or a polyolefin resin. In particular in the present invention, the other resin is preferably a copolymer of propylene and other olefinic resins. Propylene homopolymers have a relatively high melting point and rigidity, but many copolymers of propylene and other olefinic resins have a relatively low melting point and rigidity, and thus, it is possible to expand the processing temperature range by using such polymers in a mixture. It is also possible by using a hard resin and a soft resin in combination to improve the bending processability of the backsheet for photovoltaic module in the present embodiment, to prevent whitening thereof, and to improve the dimensional stability and others. Further during production of a photovoltaic module by using the backsheet for photovoltaic module of the present embodiment, it is possible by using such a resin to improve the bonding strength between the resin and the backside encapsulant layer drastically when they are bonded to each other, for example, by vacuum lamination.

The copolymer of the propylene and other olefinic resins is not particularly limited, if it is compatible with the propylene homopolymer. A copolymer of propylene and an α-olefin is preferably used, and specifically, a random copolymer of propylene and ethylene is used favorably.

When a mixture of a polypropylene homopolymer and a copolymer of propylene and other olefinic resins is used as the polypropylene resin, the mixture ratio of the polypropylene homopolymer is not particularly limited, if it is in the range that provides the resin film with desired physical properties for example according to the application of the backsheet for photovoltaic module of the present embodiment. Normally, it is preferably in the range of 5 mass % to 50 mass %, and particularly preferably in the range of 10 mass % to 30 mass %.

### (2) Resin film

The resin film for use in the present embodiment is, for example, an unstretched film without stretching or a stretched film after stretching in the uniaxial or biaxial direction. In particular in the present embodiment, an unstretched film is used favorably. When a stretched film is used, in production of a photovoltaic module by using the backsheet for photovoltaic module of the present embodiment, the film may be contracted drastically by thermocompression bonding, resulting in deterioration in productivity, but there is no such problem occurred when an unstretched film is used. For example if the backsheet for photovoltaic module in the present embodiment has a configuration of multiple films layered, a stretched film may influence on the shrinkage rate of the entire backsheet, while the influence by an unstretched film is much smaller.

The resin film used in the present embodiment may contain additives as needed. The additives for use in the present embodiment include coloring additives, ultraviolet absorbents, stabilizers, and flame retardants, and the like.

Examples of the coloring additives used in the present embodiment include various dyes and pigments covering achromatic colorants such as whitener and blackener and chromatic colorants such as of red, orange, yellow, green, blue, purple and others in color. In the present embodiment, one or more of these coloring additives may be used in combination.

The whitener is added, aimed at reflecting or diffusing and thus recycling the sunlight for power generation in the photovoltaic device by the backsheet in the photovoltaic module using the backsheet for photovoltaic module of the present embodiment. Addition of such a whitener to the resin film is also effective in giving favorable design and appearance to the photovoltaic module. If the photovoltaic module is installed, for example, on roof, it is possible to reflect or diffuse the reflecting sunlight. In addition, it is possible to improve the durability of the backsheet for photovoltaic module in the present embodiment by adding a whitener having an ultraviolet ray-absorbing action.

Examples of the whiteners for use include white pigments such as basic lead carbonate, basic lead sulfate, basic lead silicate, zinc white, zinc sulfide, lithopone, antimony trioxide, anatase titanium oxide, and rutile titanium oxide. The whiteners may be used alone or as a mixture of two or more in the present invention.

The addition amount of the whitener in the resin film when added is not particularly limited, if it is in the range of providing the resin film with desired light reflectivity or diffusivity. Normally, it is preferably in the range of 0.1 mass % to 30 mass %, particularly preferably in the range of 0.5 mass % to 10 mass % in the resin film.

In the present invention, an achromatic dye or pigment of gray in color in combination of a whitener and a blackener described below may be used.

The blackener is added for providing the film with favorable design and appearance suitable for the ambient environment, for example when the photovoltaic module using the backsheet for photovoltaic module in the present embodiment is installed on roof. Examples of the blackeners for use include carbon blacks (channel and furnace), iron oxide black, and others, and these blackeners may be used alone or in combination of two or more. The black layer formed with the blackener may be a black layer in any color, suchasbrown, brownishblack, orgrayish black.

The addition amount of the blackener in the resin film when added is not particularly limited, if it is in the range providing the resin film with favorable desired and appearance. Normally, it is preferably in the range of 0.1 mass % to 30 mass %, particularly preferably in the range of 0.5 mass % to 10 mass % in the resin film.

The chromatic colorant of dye or pigment is added for providing the film with favorable design and appearance suitable for the ambient environment, for example when the photovoltaic module using the backsheet for photovoltaic module in the present embodiment is installed on roof. Examples of the colorants include organic dye/pigment-based colorants such as azo colorants, anthraquinone colorants, phthalocyanine colorants, thioindigo colorants, quinacridone colorants, and dioxazine colorants; and inorganic pigment-based colorants such as iron blue, chrome vermilion, andbengala. In the present embodiment, among the chromatic colorants above, use of a bluish colorant is preferable. The colorant is more favorable in design and appearance, because polycrystalline silicon photovoltaic devices mostly used in current photovoltaic modules are bluish in color. In the present embodiment, the colorants may be used alone or as a mixture of two or more.

The addition amount of the colorant in the resin film when added is not particularly limited, if is in the range providing the resin film with favorable appearance. Normally, it is preferably in the range of 0.1 mass % to 30 mass %, particularly preferably in the range of 0.5 mass % to 10 mass % in the resin film.

The ultraviolet absorbent used in the present embodiment is an agent for absorbing harmful ultraviolet rays in the sun light and converting the ultraviolet rays into harmless heat energy in the molecules and accordingly preventing excitation of the active species which initiate photo-deterioration in the resin film. For example, in the embodiment, one kind or two or more of inorganic type ultraviolet absorbents selected from a group of consisting of benzophenone type, benzotriazole type, salicylate type, acrylonitrile type, metal complex salt type, hindered amine type ultraviolet absorbents, ultra fine particles of titanium oxide (particle diameter: 0.01 µm to 0.06 µm), and ultra fine particles of zinc oxide (particle diameter: 0.01 µm to 0.04 µm) can be used.

In the present embodiment, the addition amount of the ultraviolet absorbent in the resin film when added is not particularly limited, if it is in the range providing the resin film with favorable ultraviolet-absorbing efficiency. Normally, it is preferably in the range of 0.1 mass % to 10 mass %, particularly preferably in the range of 0.3 mass % to 10 mass % in the support.

The light stabilizer used in the present embodiment is an agent for catching active species which initiate photo-deterioration in the resin film and accordingly preventing photooxidation. For example, one kind or two or more of compounds selectedfrom hindered aminetype compounds, hinderedpiperidine type compounds, and others can be used in the present embodiment.

In the present embodiment, the addition amount of the light stabilizer in the resin film when added is not particularly limited, if it is in the range providing the resin film with favorable light stability. Normally, it is preferably in the range of 0.1 mass % to 10 mass %, particularly preferably in the range of 0.3 mass % to 10 mass % in the support.

The resin film used in the present embodiment preferably contains a flame retardant. The flame retardants for use in the present embodiment include both organic and inorganic flame retardants. Examples of the organic flame retardants include phosphorus-based,phosphorusand halogen-based,chlorine-based, andbromine-based flame retardants, and examples of the inorganic flame retardants include aluminum hydroxide, antimony-based flame retardants, magnesium hydroxide, guanidine-based and zirconium-based retardants, and zinc borate. In the present embodiment, it is possible to provide the backsheet for photovoltaic module in the present embodiment with favorable flame resistance by arbitrarily adding one or more of the flame retardants above.

The thickness of the resin film used in the present embodiment is not particularly limited, and may be determined for example according to the application of the backsheet for photovoltaic module in the present embodiment. Normally, it is preferably in the range of 10 µm to 300 µm, particularly preferably in the range of 15 µm to 150 µm.

The resin film used in the present embodiment preferably has a heat shrinkage rate at 150°C for 30 minutes of 3.0% or less, more preferably 1.0% or less, and particularly preferably in the range of 0.5% to 0.3%. It is because when the heat shrinkage rate of the resin film is in the range above, the resin film is less influential on the shrinkage rate of the backsheet for photovoltaic module of the present invention and makes it easier to produce a backsheet for photovoltaic module superior in appearance.
The heat shrinkage rate can be determined according to the Testing methods of plastic films for electrical purposes specified in JIS C2151.

Hereinafter, the method of producing the resin film used in the present embodiment will be described. The method of producing the resin film used in the present embodiment is not particularly limited, if it is a method giving a uniform film having a desired thickness. Methods of producing such a resin film include: a solution casting method of forming a film by casting on a support a polypropylene resin solution containing the polypropylene resin described above dissolved in a solvent; and a melt-casting method of forming a film by melt-extruding a polypropylene resin composition containing a meltage of polypropylene resin. In the present embodiment, the resin film is particularly preferably produced by the melt-casting method. It is because the melt-casting method is lower in production cost than the solution casting method, and does not require a drying step, and thus allows acceleration of the casting speed.

In production of a resin film by the melt-casting method, a polypropylene resin film is produced, for example, by preparing a polypropylene resin composition by adding above-mentioned additives to the polypropylene resin, blending the mixture thoroughly, and then, forming a film, for example by extrusion method, T die extrusion method, cast molding method, inflation molding, or other film-forming method. The polypropylene resin film formed may be stretched as needed by a tenter or tubular method in the uniaxial or biaxial direction.

### 2. Hydrolysis-resistant film

Hereinafter, the hydrolysis-resistant film used in the backsheet for photovoltaic module in the present embodiment will be described. The hydrolysis-resistant film used in the present embodiment is characteristically made of a polyester resin having a carboxy end-group content of 15 equivalent/ton or less.

### (1) Polyester resin

The polyester resin for the hydrolysis-resistant film used in the present embodiment will be describedbelow. The polyester resin used in the present embodiment is characteristically made of a polyester resin having a carboxy end-group content of 15 equivalent/ton or less. In the present embodiment, it is possible to make the backsheet for photovoltaic module in the present embodiment superior in hydrolysis resistance, by using a polyester resin having carboxy terminal groups in such an amount.

The polyester resin for use in the present embodiment has a carboxy end-group content of 15 equivalent/ton or less. In the present embodiment, the carboxy end-group content of a polyester resin is defined as described above, because, when the carboxy end-group content is larger than the range above, hydrolysis reaction of the polyester resin progresses under high-temperature high-humidity atmosphere, damaging the durability of the backsheet for photovoltaic module in the present embodiment. In the present embodiment, the carboxy end-group content is more preferably in the range of 12 equivalent/ton to 5 equivalent/ton.

The terminal carboxyl group amount in the present embodiment is determined by dissolving the hydrolysis-resistant film used in the present embodiment in a particular amount in o-cresol/chloroform (weight ratio: 50/50 or 60/40), phenol/1,2-dichlorobenzene (weight ratio: 50/50), phenol/1,1,2,2-tetrachloroethane (weight ratio: 50/50 or 60/40), O-chlorophenol, or dichloroacetic acid and titrating the solution with alkali potentiometrically.

The polyester resin for use in the present embodiment preferably has an intrinsic viscosity of 0.8 dl/g or more. Use of the polyester resin having an intrinsic viscosity of 0.8 dl/g or more makes the backsheet for photovoltaic module of the present invention superior in toughness, rigidity, and heat resistance. In the present embodiment, the intrinsic viscosity is more preferably 1.0 dl/g or more, and still more preferably in the range of 1.2 dl/g to 1.5 dl/g.

In the present embodiment, the intrinsic viscosity is a viscosity as determined by dissolving the hydrolysis-resistant film used in the present embodiment in a solvent such as phenol/1,2-dichlorobenzene (weight ratio: 50/50), phenol/1,1,2,2-tetrachloroethane (weight ratio: 50/50 or 60/40), O-chlorophenol, or dichloroacetic acid at a concentration of 0.1 g/ml and measuring the viscosity of the dissolved solution at 25°C.
Although it is generally quite simple to measure the viscosity of a dilute solution of fine particles or a polymeric substance, the measurement is often very effective in understanding the physical properties thereof. The ratio of ηᵣ =η/η₀, wherein η is the viscosity of the solution containing a desired substance and η₀ is the viscosity of the solvent, is called relative viscosity. Viscosity ηₛₚ, a value of the relative viscosity ηᵣ subtracted by 1, i.e., ηₛₚ = ηᵣ₁ = (η-η₀)/η₀, is called specific viscosity, and corresponds to the increase in viscosity by solubilization of a desired substance in a solvent. The specific viscosity ηₛₚ is a function of the concentration of the desired substance, and the specific viscosity extrapolated to a concentration of 0 is the intrinsic viscosity (limiting viscosity). The intrinsic viscosity is a physical parameter that can be correlated with the particle diameter and the molecular weight of the solute present as dispersed in the solution and thus, contains useful information. The viscosity of the solution is a value obtained according to the test method of Plastics - Determination of the viscosity of polymers in dilute solution using capillary viscometers - Part 5: Thermoplastic polyester (TP) homopolymers and copolymers specified in JIS K7367-5.

The content of oligomers in the polyester resin for use in the present embodiment is preferably in the range providing the hydrolysis-resistant film with favorable hydrolysis resistance for example according to the application of the backsheet for photovoltaic module in the present embodiment. The oligomer content has correlation with the carboxy end-group content in the polyester resin. Increase of the oligomeric content leads to increase of the carboxy end-group content and further, to deterioration of the hydrolysis resistance. Decrease of the oligomeric content leads to decrease of the carboxy end-group content and further to improvement of the hydrolysis resistance. In the present embodiment, the content of the oligomers in the polyester resin is preferably in the range of 0.4 mass % or less, more preferably in the range of 0.3 mass % to 0.1 mass %, and particularly preferably in the range of 0.2 mass % to 0.1 mass %.

In the present embodiment, the oligomer means low-molecular weight polymers having a repetition number (polymerization degree) of the polyester resin-constituting structural units of about 2 to 20. The content of oligomers in the polyester resin is determined for example, by dissolving the polyester resin in an amount of 100 mg in 2 ml of a solvent such as phenol/1,2-dichlorobenzene (weight ratio: 50/50), phenol/1,1,2,2-tetrachloroethane (weight ratio: 50/50 or 60/40), O-chlorophenol, or dichloroacetic acid and analyzing the solution by liquid chromatography (HLC803D, manufactured by Toso Sangyo Co. Ltd.), and is expressed as a oligomer rate (mass %) with respect to the polyester resin.

In addition, the number-average molecular weight of the polyester resin for use in the present embodiment is preferably in the range providing the hydrolysis-resistant film with favorable hydrolysis resistance for example according to the application of the backsheet for photovoltaic module in the present embodiment. The number-average molecular weight has correlation with the carboxy end-group content in the polyester resin film; increase of the number-average molecular weight leads to decrease of the carboxy end-group content and improvement in the hydrolysis resistance; and on the other hand, decrease of the number-average molecular weight leads to increase of the carboxy end-group content and thus to improvement in the hydrolysis. In the present embodiment, the number-average molecular weight is preferably in the range of 18, 500 to 40, 000, more preferably in the range of 19,000 to 35,000.

In the present embodiment, the number-average molecular weight is a value obtained by GPC (gel permeation chromatography) under the following condition:
(a) Apparatus: gel penetration chromatograph GCP-244 (manufactured by WATERS CORPORATION)
(b) Column: two columns of ShodexHFIP80M (manufactured by Showa Denko K.K.)
(c) Solvent: hexafluoropropanol (0.005N-sodium trifluoroacetate)
(d) Flow rate: 0.5 ml/minute
(e) Temperature: 23°C
(f) Sample: concentration: 0.06%, solubility: complete solubilization, and filtration: Myshori (transliteration) Disk W-13-5
(g) Injection: 0.300 ml
(h) Detector: R-401 differential refractometer (WATERS CORPORATION)
(i) Molecular weight calibration: PET-DMT (standard)

The polyester resin for use in the present embodiment is not particularly limited, if it is a resin having a carboxy end-group content in the range above and that is produced from a dicarboxylic acid compound and a diol compound in condensation.

The dicarboxylic acid compound for the polyester resin used in the present embodiment is not particularly limited, and, for example, an aromatic dicarboxylic acid, an alicyclic dicarboxylic acid, or a fatty dicarboxylic acid may be used.

Examples of the aromatic dicarboxylic acid components for the aromatic dicarboxylic acid include terephthalic acid, isophthalic acid, phthalic acid, 1,4-naphthalenedicarboxylic acid, 1,5-naphthalenedicarboxylic acid, 2,6-naphthalenedicarboxylic acid, 4,4'-diphenyldicarboxylic acid, 4,4'-diphenyletherdicarboxylic acid, and 4,4'-diphenylsulfonedicarboxylic acid. In particular in the present embodiment, terephthalic acid, phthalic acid or 2,6-naphthalenedicarboxylic acid is used favorably.

Examples of the alicyclic dicarboxylic acids include cyclohexanedicarboxylic acid.

Examples of the fatty dicarboxylic acid components include adipic acid, suberic acid, sebacic acid, and dodecandionic acid.

In the present embodiment, the dicarboxylic acid compounds may be used alone or in combination of two or more, and an oxy acid such as hydroxyethoxybenzoic acid may be copolymerized partly.

The diol compound for the polyester resin for use in the present embodiment is not particularly limited, if it gives a polyester resin by condensation with the dicarboxylic acid above . Examples of the diol compounds for use in the present embodiment include ethylene glycol, 1,2-propanediol, 1,3-propanediol, neopentylglycol, 1,3-butanediol, 1,4-butanediol, 1,5-pentanediol, 1,6-hexanediol, 1,2-cyclohexanedimethanol, 1,3-cyclohexanedimethanol, 1,4-cyclohexanedimethanol, diethylene glycol, triethylene glycol, polyalkylene glycols, and 2,2'-bis(4'-β-hydroxyethoxyphenyl)propane.
In particular in the present embodiment, use of ethylene glycol, 1,4-butanediol, 1,4-cyclohexanedimethanol, or diethylene glycol is preferable, and use of ethylene glycol is most preferable.

In the present embodiment, the diol components may be used alone or in combination of two or more.

The polyester resin formed by condensation of the dicarboxylic acid compound and the diol compound is not particularly limited, and any polyester resin prepared in any combination of the dicarboxylic acid compound and the diol compound may be used. In particular in the present embodiment, use of polyethylene terephthalate, polyethylene naphthalate, or polyethylene 2,6-naphthalenedicarboxylate is preferable, and use of polyethylene terephthalate is most preferable.

Although the polyester resin is prepared by condensation of the dicarboxylic acid compound and the diol compound, the polyester resin may be copolymerized with other compounds including trimellitic acid, pyromellitic acid, glycerol, pentaerythritol, 2,4-dioxybenzoic acid, and monofunctional compounds such as lauryl alcohol and phenyl isocyanate, if the resulting polymer remains substantially linear.

The polyester resin in the present embodiment is produced, for example, by: a method of esterifying an acid component directly with a diol component; a method of using a dialkyl ester as the acid component, carrying out a first-phase reaction with the diol component by ester-exchange reaction, and subsequently carrying out a second-phase reaction of melt-polymerizing the reaction product while removing the excess diol component while heated under reduced pressure; or a method of further carrying out a third-phase reaction of polymerizing the second-phase reaction product in the solid phase. In the present embodiment, it is desirable to use the solid-phase polymerization, to obtain a polyester resin having a smaller carboxy end-group content.

The method of the solid-phase polymerization is not particularly limited, and any known method may be used. For example, the resin may be crystallized preliminary at a temperature of 180°C or lower and then heated under nitrogen stream or under vacuum at 1 torr or lower at a temperature in the range of 180°C to the melting point (approximately 250°C) for 5 to 50 hours.

The polyester resin for use in the present embodiment may contain, for example, a polyether compound additionally for adjustment of the intrinsic viscosity in a desired range. The polyether compound for use in the present embodiment is not particularly limited, and, for example, polyethyleneoxide or a polyether compound containing a diol as the principal component may be used.

Examples of the diol include ethylene glycol, 1,2-propanediol, 1,3-propanediol, neopentylglycol, 1,3-butanediol, 1,4-butanediol, 1,5-pentanediol, 1,6-hexanediol, 1,2-cyclohexanedimethanol, 1,3-cyclohexanedimethanol, 1,4-cyclohexanedimethanol, diethylene glycol, triethylene glycol, polyalkylene glycols, and 2,2'-bis(4'-β-hydroxyethoxyphenyl)propane.

The polyether compound favorably used in the present embodiment is, for example, a polyether compound containing at least one polymer selected from the group consisting of polyethyleneoxide, polyethylene glycol, polypropylene glycol, polytetramethylene glycol, and the copolymers of these polyether compounds.

The polyether compound for use may be a terminal-blocked polyether compound. It is because the terminal-blocked polyether compound advantageously inhibits hydrolysis of the polyester resin. The terminal-blocked polyether compound is, for example, a polyether compound with its polyether terminal hydroxyl groups alkyletherified, i.e., terminal-blocked with a methoxy, ethoxy or other group.

The average molecular weight of the polyether compound is not particularly limited, but preferably 500 to 10, 000, more preferably 700 to 5,000. An average molecular weight of less than 500 is disadvantageous, because the compound is less soluble in the polyester resin. On the other hand, an average molecular weight of more than 10,000 may lead to deterioration in compatibility with the polyester resin.

The content of the polyether compound for use in the present embodiment is not particularly limited. Normally, it is preferably in the range of 0.1 mass % to 10 mass %, more preferably in the range of 0.2 mass % to 7 mass %, and particularly preferably in the range of 0.2 mass % to 5 mass %, in the polyester resin.

The polyester resin for use in the present embodiment may contain as needed various additives such as flame retardant, heat stabilizer, antioxidant, ultraviolet absorbent, antistatic agent, pigment and dye, organic lubricant such as fatty acid ester or wax, and antifoam such as polysiloxane. In addition for improvement in sliding property, abrasion resistance, and scratch resistance, inorganic particles such as of clay, mica, titanium oxide, calcium carbonate, kaolin, talc, wet or dry silica, colloidal silica, calcium phosphate, barium sulfate, alumina, and zirconia, and organic particles such as resins containing an acrylic acid or styrene as the constituent component maybe added; so-called internal particles that precipitate by addition of a catalyst or the like during polyester polymerization reaction may be added; and also, a surfactant may be added.

### (2) Hydrolysis-resistant film

The apparent density of the hydrolysis-resistant film used in the present embodiment is not particularly limited, if it is the range providing the hydrolysis-resistant film with favorable mechanical strength, for example according to the application of the backsheet for photovoltaic module in the present embodiment. In particular in the present embodiment, the apparent density is preferably in the range of 1.37 g/cm³ to 0.85 g/cm³, more preferably in the range of 1.35 g/cm³ to 0 . 9 g/cm³, and particularly preferably in the range of 1.3 g/cm³ to 0.9 g/cm³_{.}
In the present embodiment, the apparent density can be determined by measuring the mass of a hydrolysis-resistant film with known volume.

The thickness of the hydrolysis-resistant film used in the present embodiment is not particularly limited and may be determined arbitrarily in the range providing the backsheet for photovoltaic module in the present embodiment with desired self-supporting properties. In particular in the present invention, the thickness is preferably in the range of 3 µm to 500 µm, more preferably in the range of 25 µm to 250 µm, and particularly preferably in the range of 25 µm to 188 µm. The thickness for use is a value as determined according to the Testing methods of plastic films for electrical purposes specified in JIS C2151.

From the viewpoint of the short-circuiting resistance of the backsheet for photovoltaic module of the present embodiment, the specific volume resistivity of the hydrolysis-resistant film used in the present embodiment is preferably approximately 1×10¹⁸ Ω/cm; the dielectric breakdown voltage thereof, in the range of 5 to 50 kV; and the dielectric constant, approximately 3.3 (1kHz). These properties for use are values determined according to the Testing methods of plastic films for electrical purposes specified in JIS C2151.

The hydrolysis-resistant film used in the present embodiment may have a single-layered structure or a multi-layered structure. The multi-layered structure is not particularly limited, but it is, for example, a layered structure having a film of the polyester resin and another polymer layer of such as polyester, polyolefin, polyamide, polyvinylidene chloride, or acrylic polymer laminated thereon.

The hydrolysis-resistant film used in the present embodiment preferably has a heat shrinkage rate at 150°C for 30 minutes of 1.0% or less, more preferably 0.5% or less, and most preferably in the range of 0.1% to 0.5%. In production of a photovoltaic module by using the backsheet for photovoltaic module in the present embodiment, it is possible, when the heat shrinkage rate is in such a range above, to prevent deformation of the backsheet for photovoltaic module caused by heat shrinkage and thus to improve the productivity of the photovoltaic module with the backsheet for photovoltaic module of the present invention.
The heat shrinkage rate can be determined according to the Testing methods of plastic films for electrical purposes specified in JIS C2151.

The method of producing a hydrolysis-resistant film for use in the present embodiment is not particularly limited, if it is a method of forming a film uniformly at a desired thickness. Description on the method of forming a hydrolysis-resistant film is omitted, because a method similar to that of producing a resin film described in the section of "1. Resin film" may be used as the method.

### 3. Other components

The backsheet for photovoltaic module in the present embodiment may have components other than the resin film and the hydrolysis-resistant film. An example of such a component is a gas barrier film. In the present embodiment, the backsheet particularly preferably has a gas barrier film for improvement in moisture barrier characteristics thereof.

### (1) Gas barrier film

The gas barrier film for use in the present embodiment will be described. The gas barrier film is not particularly limited, if it has a function to provide the backsheet for photovoltaic module in the present embodiment with desired moisture barrier characteristics. Normally, a configuration consisting of a base film and a gas-barrier layer formed on at least one surface of the base film is used.

The embodiment of such gas barrier film that is formed on the backsheet for photovoltaic module in the present embodiment is not particularly limited, if it is a filmproviding the backsheet for photovoltaic module in the present embodiment with desired moisture barrier characteristics and allowing stable preservation of the desired moisture barrier characteristics for a long period of time. Such embodiments include: an embodiment of laminating a gas barrier film on the hydrolysis-resistant film; an embodiment of laminating a gas barrier film on the resin film; and an embodiment of forming a gas barrier film between the hydrolysis-resistant film and the resin film. Alternatively when multiple gas barrier films are used, a combination of the embodiments above may be used. In particular in the present embodiment, the embodiment of forming a gas barrier filmbetween the hydrolysis-resistant film and the resin film is preferable. In such a configuration, it is possible to improve the temporal stability of the moisture barrier characteristics.

Specifically, the embodiment of the gas barrier film formed between the hydrolysis-resistant film and the resin film is shown, for example, in FIG. 2 described above. The backsheet for photovoltaic module 11 exemplified in FIG. 2 is an embodiment having a gas barrier film 5 comprising a base film 3 and a gas-barrier layer 4 formed between the hydrolysis-resistant film 1 and the resin film 2. In FIG. 2, the gas barrier film 5 is formed with its the gas-barrier layer 4 facing the hydrolysis-resistant film 1, but gas barrier film 5 may be formed in the opposite configuration, i.e., with the gas-barrier layer 4 facing the resin film 2.

When gas barrier films are used in the backsheet for photovoltaic module of the present embodiment, the number of the gas barrier films is not particularly limited, and may be one, or two or more. The number of the gas barrier films used is determined suitably, for example according to the application of the backsheet for photovoltaic module in the present embodiment, by taking into consideration the moisture barrier characteristics required for the backsheet for photovoltaic module and the moisture barrier characteristics of the gas barrier film. In particular for simplification of the production process of the backsheet for photovoltaic module of the present embodiment, use of one or two gas barrier films is preferable.

An embodiment of two gas barrier films being used in the backsheet for photovoltaic module in the present embodiment will be described below with reference to drawings. FIG. 3 is a schematic sectional view illustrating an example of the backsheet for photovoltaic module in the present embodiment having two gas barrier films. An embodiment of the case when two gas barrier films are used in the backsheet for photovoltaic module of the present embodiment is the configuration shown in FIG. 3, wherein two gas barrier films 5 comprising a base film 3 and a gas-barrier layer 4 are formed between the hydrolysis-resistant film 1 and the resin film 2.

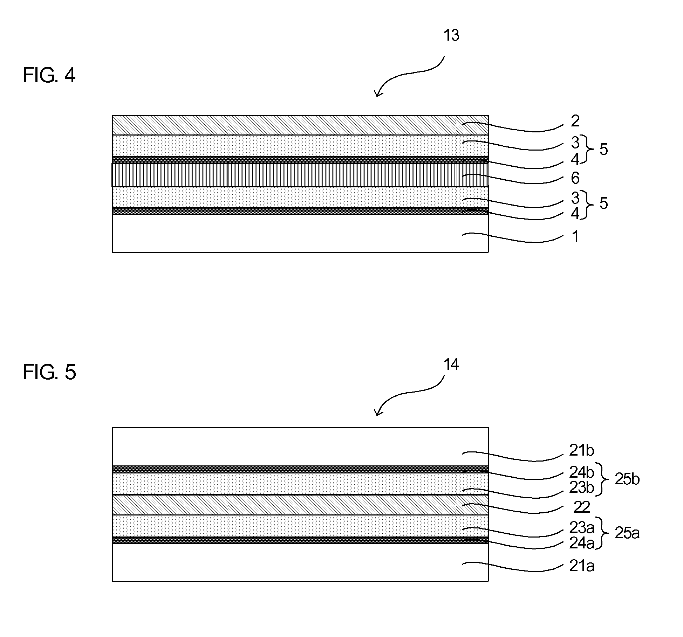

FIG. 4 is a schematic sectional view illustrating another embodiment wherein the backsheet for photovoltaic module in the present embodiment has two gas barrier films. As shown in FIG. 4, in another embodiment of the backsheet for photovoltaic module in the present embodiment having two gas barrier films, two gas barrier films 5 laminated via a tough film 6 are placed between the hydrolysis-resistant film 1 and the resin film 2.

Hereinafter, each component for the gas barrier film will be described.

### i. Base film

First, the base film used in the gas barrier film will be described. The material for the base film for use in the present embodiment is not particularly limited, if it has a durability withstanding the processing condition during the gas-barrier layer described below is formed and is adhesive to the gas-barrier layer, and favorable materials may be selected suitably according to the various physical properties required for the backsheet for photovoltaic module in the present embodiment.

Specific examples of the materials for the base film include: polyethylene resins, polypropylene resins, cyclic polyolefin resins, polystyrene resins such as syndiotactic polystyrene resin, acrylonitrile-styrene copolymers (AS resins), acrylonitrile-butadiene-styrene copolymers (ABS resins), polyvinylchloride resins, fluorine resins, poly (meth)acrylic resins, polycarbonate resins, polyester resins such as polyethylene terephthalate and polyethylene naphthalate, polyamide resins such as various nylons, polyimide resins, polyamide-imide resins, polyaryl phthalate resins, silicone resins, polysulfone resins, polyphenylenesulfide resins, polyethersulfone resins, polyurethane resins, acetal resins, and cellulosic resins.
In the present embodiment, among the materials above, use of a cyclic polyolefin resin, a polycarbonate resin, a poly (meth) acrylic resin, a polystyrene resin, a polyamide resin or a polyester resin is preferable. This is because it is possible by using such a material to make the backsheet for photovoltaic module in the present embodiment favorable in durability and superior in processing compatibility. Also in the present embodiment, the materials for the base film described above may be used alone or in combination of two or more.

The thickness of the base film may be determined properly according to the various physical properties required for the backsheet for photovoltaic module of the present embodiment. Normally, it is preferably in the range of 9 µm to 300 µm, more preferably in the range of 12 µm to 200 µm.

The base film may contain as needed other additives. Examples of the additives used in the present embodiment include lubricant, crosslinking agent, antioxidant, ultraviolet absorbent, light stabilizer, encapsulant, lubricant, reinforced fiber, reinforcing agent, antistatic agent, flame retardant, flame resistant agent, foaming agent, fungicide, and pigment, as well as modifying resin. Particularly in the present embodiment, among the additives above, use of an ultraviolet absorbent, a light stabilizer, and an antioxidant is preferable.

As the ultraviolet absorbent, one kind or more of inorganic type ultraviolet absorbents selected from a group of consisting of benzophenone type, benzotriazole type, salicylate type, acrylonitrile type, metal complex salt type, ultra fineparticles of titanium oxide (particle diameter: 0.01 µm to 0.06 µm), and ultra fine particles of zinc oxide (particle diameter: 0.01 µm to 0.04 µm) can be used.

As the light stabilizer, one kind or more of compounds selectedfrom hindered aminetype compounds, hinderedpiperidine type compounds, and others can be used.

The antioxidant is a compound preventing oxidative degradation and others of base film caused by for example light or heat, and examples thereof for use include phenol-based, amine-based, sulfur-based, phosphoric acid-based, and other antioxidants.

Examples of the ultraviolet absorbents, light stabilizers and antioxidants for use include polymeric ultraviolet absorbents, light stabilizers or antioxidants containing chemically bonded an ultraviolet absorbent such as benzophenone, a light stabilizer such as a hindered amine compound, or an antioxidant such as a phenol-based antioxidant on the main or side chains of the polymer.

The contents of the ultraviolet absorbent, light stabilizer and antioxidant are determined according to the various physical properties required for the base film. Normally, they are preferably in the range of 0.1 mass to 10 mass % in the base film.

For improvement of the adhesiveness of the base film to the gas-barrier layer described below, the base film may have a surface-finished layer previously formed. Examples of the surface-finished layers include corona-treated layer, ozone-treated layer, plasma-treated layer, and oxidized layer that are formed respectively by corona discharge treatment, ozone treatment, plasma treatment by using gas such as oxygen or nitrogen, glow discharge treatment, and chemical surface treatment for example by oxidation with a chemical.
The surface treatment may be carried out in a separate step, or for example, when surface treatment such as plasma treatment or glow discharge treatment is performed, the surface treatment may be carried out as in-line pretreatment before an inorganic-oxide vapor-deposition film described below is formed, and such a method is advantageously effective in reducing the production cost.

The surface-finished layer is formed as the means of improving the adhesiveness between the base film and the gas-barrier layer described below. In addition to the surface-finished layer, for example, a coating agent layer such as primer coating agent layer, undercoat agent layer, anchor-coating agent layer, adhesive agent layer, or vapor deposition anchor-coating agent layer may be formed on the surface of the base film, as the means of improving the adhesiveness. Examples of the materials for the coating agent layer include polyester resins, polyamide resins, polyurethane resins, epoxy resins, phenol resins, (meth)acrylic resins, polyvinyl acetate resins, polyolefin resins such as polyethylene and polypropylene, and the copolymers or the modified resins thereof, and cellulosic resins.

In the present embodiment, in the step of forming a gas-barrier layer described below on at least one surface of the base film, a vapor-deposition protective film may be formed on at least one surface of the base film for protection of the base film. Such a vapor-deposition thin film of inorganic oxide is formed on a base film, for example, by a chemical vapor deposition method (CVD method) such as chemical vapor deposition method, thermochemical vapor deposition method, or photochemical vapor deposition method, or a physical vapor deposition method (PVD method) such as vacuum deposition method (resistance-heating, induction-heating, or EB-heating), sputtering method, or ion plating method.
The inorganic oxide for the vapor-deposition protective film is not particularly limited, but, for example, silicon oxide may be used.

The thickness of the vapor-deposition protective film is desirably less than 150 Ǻ. More specifically, it is preferably in the range of 10 to 100 Ǻ, more preferably in the range of 20 to 80 Ǻ, and particularly preferably in the range of 30 to 60 Ǻ. A film thickness of larger than the range above may make it difficult to form a uniformvapor-deposition protective film, while a film thickness of smaller than the range may result in insufficient protection of the base film.

### ii. Gas-barrier layer

Hereinafter, the gas-barrier layer in the gas barrier film will be described. The gas-barrier layer is not particularly limited, if it can provide the gas barrier film with desired moisture barrier characteristics, and examples thereof include thin metal film, vapor-deposited inorganic oxide film, and organic thin film, as well as the films in combination thereof. Particularly in the present embodiment, a vapor-deposited inorganic oxide film is used favorably. It is because the vapor-deposited inorganic oxide film, which is superior in denseness, has favorable moisture barrier characteristics per unit thickness and is superior in adhesiveness to the base film.

The vapor-deposited inorganic oxide film for use in the present embodiment is not particularly limited, if it is a thin film of a vapor-deposited metal oxide. Examples of the metals used for the vapor-deposition film include silicon (Si), aluminum (Al), magnesium (Mg), calcium (Ca), potassium (K), tin (Sn), sodium (Na), boron (B), titanium (Ti), lead (Pb), zirconium (Zr), and yttrium (Y).
Particularly in the present embodiment, a vapor-deposition metal oxide film of silicon (Si) or aluminum (Al) is favorably used as the vapor-deposition film.

The content of oxygen atom in the metal oxide is not particularly limited, and may be determined arbitrarily according to the metal species of the metal oxide. The metal oxide may be expressed by MOx, wherein the metal element is represented by M, the oxygen atom by O, and the number of the oxygen atoms by X. In the metal oxide of the present embodiment, when it is expressed in this way, X is preferably 0 to 2. When silicon (Si) or aluminum (Al) is used as the metal constituting the metal oxide, the value X is preferably in the range of 1.0 to 2.0 in the case of silicon (Si), and in the range of 0.5 to 1.5 in the case of aluminum (Al).

The metal for use in the vapor-deposited inorganic oxide film may be a pure metal or an alloy of two or more metals, and the film may be a vapor-deposited inorganic oxide film of different metals.

The thickness of the vapor-deposited inorganic oxide film is normally, preferably in the range of 50 to 4000 Ǻ, particularly preferably in the range of 100 to 1000 Ǻ, according to factors such as the kind of the metal or metal oxide used.
When the vapor-deposited inorganic oxide film has a multi-layered structure, the thickness above denotes to the total thickness.

The gas-barrier layer used in the present embodiment may have a single-layer structure or a multi-layered structure. When it has a multi-layered structure, it may be lamination of layers in the same composition or of layers different in composition.

### iii. Gas barrier film

The gas barrier properties of the gas-barrier layer used in the present embodiment are not particularly limited, if they are in the range providing the backsheet for photovoltaic module in the present embodiment with desired moisture barrier properties according to the use embodiment of the gas barrier film. In particular, the oxygen gas permeability of the gas barrier film for use in the present embodiment is preferably 1 cc/m²/day/atm or less, particularly preferably 0.5 cc/m²/day/atm or less. Alternatively, the moisture permeability is preferably 1 g/m²/day or less, particularly preferably 0.5 g/m²/day or less.
The oxygen gas permeability is a value as determined by using an oxygen gas permeability analyzer (trade name: OX-TRAN 2/20, manufactured by MOCON Inc.) under the condition of a measurement temperature of 23°C and a humidity of 90% RH. Alternatively, the moisture permeability is a value as determined by using a moisture permeability analyzer (trade name: PERMATRAN-W3/31, manufactured by MOCON Inc.) under the condition of a measurement temperature 37.8°C and a humidity of 100% RH.

The configuration of the gas barrier film for use in the present embodiment is not particularly limited, if favorable gas barrier properties are obtained, but it is preferably a configuration in which the gas-barrier layer is formed at least on one side of the base film. In other words, the gas-barrier layer may be formed only on one side of the base film or on both faces of the base film.

### iv. Method of producing gas barrier film

The method of producing a gas barrier film for use in the present embodiment is not particularly limited, if it can form a uniform gas-barrier layer on the base film, according to the materials for the gas-barrier layer.

When a vapor-deposited inorganic oxide film is formed as a gas-barrier layer on the base film, the method of forming it is not particularly limited, if a uniform vapor-deposition film is formed at a desired layer thickness. In the present embodiment, the vapor-deposition film may be formed for example, by physical or chemical vapor deposition method or a method in combination thereof.

Examples of the physical vapor deposition methods include physical vapor deposition methods (PVD methods) such as vacuum deposition (resistance-heating, induction heating, or EB heating), sputtering, ion plating, and ion cluster beam method. More specifically, favorably used is a vacuum deposition method of vapor-depositing a metal oxide on a base film by using a metal oxide and heating it as a raw material, an oxidative vapor deposition method of vapor-depositing a metal or metal oxide on a base film by using and heating it as a raw material while the raw material is oxidized by oxygen supplied, or an plasma-assisted oxidative vapor deposition method of accelerating the oxidation reaction by plasma. The material for vapor deposition may be heated, for example, by resistance heating, high-frequency induction heating, or electron beam heating (EB).

Examples of the chemical vapor deposition methods include chemical vapor deposition methods (CVD) such as plasma chemical vapor deposition, thermochemical vapor deposition, and photochemical vapor deposition. More specifically, a vapor-deposited inorganic oxide film for example of silicon oxide is formed on one face of a base film, by using a monomer gas for vapor deposition such as an organic silicon compound as the raw material, an inert gas such as argon or helium gas as the carrier gas and an oxygen gas as the oxygen-supplying gas, and also by using the low-temperature plasma chemical vapor deposition method of using, for example, a low temperature plasma-generating unit. Examples of the low temperature plasma-generating units include high-frequency plasma, pulsed plasma, and microwave plasma-generation apparatuses. In the present embodiment, use of a high-frequency plasma-generating apparatus is preferable for obtaining highly active stabilized plasma.

The vapor-deposited inorganic oxide film used in the present embodiment may be a composite film of two or more-layers of vapor-deposited inorganic oxide films different in kind that are formed both by the physical and chemical vapor deposition methods in combination. A vapor-deposited inorganic oxide film of such a composite membrane having two or more layers is preferably produced by forming a dense, flexible, vapor-deposited inorganic oxide film relatively resistant to cracking by the chemical vapor deposition method and then forming another vapor-deposited inorganic oxide film by the physical vapor deposition method on the vapor-deposited inorganic oxide film.

### (2) Others

The backsheet for photovoltaic module in the present embodiment may have components other than the gas barrier film. Examples of the other components include a primer layer for installation of a terminal box.

### 4. Backsheet for photovoltaic module

The heat shrinkage rate of the backsheet for photovoltaic module in the present embodiment is preferably in such a range that, when a photovoltaic module is prepared by using the backsheet for photovoltaic module of the present embodiment according to the method of producing a backsheet for photovoltaic module of the present embodiment, the backsheet does not deform the photovoltaic module. More specifically, the heat shrinkage rate at 150°C for 30 minutes is preferably 1.0% or less, more preferably 0.5% or less, andparticularlypreferably in the range of 0.3% to 0.1%. It is because, if the heat shrinkage rate is larger than the range above, when a photovoltaic module is produced by using the backsheet for photovoltaic module of the present embodiment, the backsheet shrinks during vacuum lamination, leading to shrinkage of the photovoltaic devices and the lead wires (tags) connecting the photovoltaic devices and consequently to deformation of the lead wire and alternation of the distance between photovoltaic devices.
In the present embodiment, a shrinkage rate of 0 is favorable, because there is no contraction (or dislocation, etc.) of the backsheet during vacuum laminate, but such a backsheet only of a plastic film without use of a metal foil as in the present embodiment is rather vulnerable to the influence by heat. For obtaining a shrinkage rate of 0, there is needed a preliminary heat shrinkage treatment for reduction of the shrinkage rate, which may cause damage, for example, on the films for the backsheet.
The heat shrinkage rate can be determined according to the Testing methods of plastic films for electrical purposes specified in JIS C2151.

The backsheet for photovoltaic module in the present embodiment preferably has through-holes for connection to the terminals to withdraw the electric current generated by the photovoltaic device after production of the photovoltaic module. The shape of the through-hole is not particularly limited, and the position, size, shape and number thereof are determined arbitrarily according to factors such as the wiring pattern of the photovoltaic module using the backsheet for photovoltaic module of the present embodiment.

### 5. Method of producing backsheet for photovoltaic module

Hereinafter, the method of producing a backsheet for photovoltaic module in the present embodiment will be described. The method of producing a backsheet for photovoltaic module in the present embodiment is not particularly limited, if it is a method of laminating respective components of the backsheet for photovoltaic module in the present embodiment described above to each other effectively. In an embodiment of the method, the resin film is dry-laminated via an adhesive agent layer onto the hydrolysis-resistant film. Alternatively when the gas barrier film is used, a hydrolysis-resistant film and a resin film may be dry-laminated on both faces of the gas barrier film via an adhesive agent layer.

Examples of the adhesive agents for lamination constituting the adhesive agent layer include: polyvinyl acetate-based adhesive agents; polyacrylic ester-based adhesive agents such as homopolymers of acrylic acid ethyl, butyl, 2-ethylhexyl, or other ester or the copolymers thereof with methyl methacrylate, acrylonitrile, styrene or the like; cyanoacrylate-based adhesive agents; ethylene copolymer-based adhesive agents such as copolymers of ethylene with a monomer such as vinyl acetate, ethyl acrylate, acrylic acid, or methacrylic acid; polyolefin-based adhesive agents such as of a polyethylene resin or a polypropylene resin; cellulosic adhesive agents; polyester-based adhesive agents; polyamine-based adhesive agents; polyimide-based adhesive agents; amino resin-based adhesive agents of a urea resin or a melamine resin; phenol resin-based adhesive agents; epoxy-based adhesive agents; polyurethane-based adhesive agents; reactive (meth)acrylic adhesive agents; rubber-based adhesive agents such as of chloroprene rubber, nitrile rubber, styrene-butadiene rubber, and styrene-isoprene rubber; silicone-based adhesive agents; and inorganic adhesive agents such as alkali metal silicates and low-melting-point glasses. As for the composition, the adhesive agent may be in any type such as aqueous type, solution type, emulsion type, or dispersion type and in any shape such as sheet-shaped, powdery or solid; and the adhesion mechanism may be chemical reaction, solvent vaporization, heat fusion, thermocompression, or the like.

In the present embodiment, use of a rubber-based adhesive agent such as styrene-butadiene rubber or styrene-isoprene rubber as the adhesive agent is preferable. This is because it is a resin superior in hydrolysis resistance and most suitable for the low-temperature resistance required in present applications.

The adhesive agent layer preferably contains a hardening agent or crosslinking agent additionally for crosslinking the adhesive agent. This is because it is possible to obtain an adhesive agent layer superior in heat resistance, moist heat resistance and others by forming a crosslinked structure.

The hardening or crosslinking agent is, for example, an isocyanate compound such as aliphatic-alicyclic isocyanate or aromatic isocyanate, more specifically, 1,6-hexamethylene diisocyanate (HDI), isophorone diisocyanate (IPDI), tolylene diisocyanate (TDI), diphenylmethane diisocyanate (MDI), naphthylene diisocyanate (NDI), tolidine diisocyanate (TODI), or xylylene diisocyanate (XDI).

The adhesive agent is applied onto the gas barrier film, hydrolysis-resistant film, and resin film, for example, by a coating method such as roll coating, gravure roll coating, or kiss coating or a printing process. The coating amount is preferably in the range of 0.1 to 10 g/m² (dry state).

The adhesive agent may contain the ultraviolet absorbent or the light stabilizer described above for prevention of ultraviolet deterioration. The ultraviolet absorbents or the light stabilizers described above may be used alone or in combination of two or more as the ultraviolet absorbent or the light stabilizer. The amount thereof may vary according to factors such as the particle shape and density, but is preferably in the range of 0.1 mass % to 10 mass % in the adhesive agent.

In the present embodiment when two or more of the gas barrier films are used as laminated, the gas-barrier layers or the base films maybe laminated as they face each other, or alternatively, a gas-barrier layer and another base film are laminated as they face each other. The lamination method is not particularly limited, and, for example, the dry lamination method described above may be used.

Also in the present embodiment, if two gas barrier films are laminated via a tough resin film, the base film constituting the gas barrier film may face the tough film, or the gas-barrier layer for the gas barrier film may face the tough film. In addition, the surfaces of the two gas barrier films facing the tough film may be the same as or different from each other. The method of laminating two gas barrier films via a tough resin film is not particularly limited, and, for example, the dry laminate method described above may be used.

In the present embodiment, for example, a tough resin film or sheet of a polyester resin, a polyamide resin, a polyaramide resin, apolypropyleneresin, apolycarbonateresin, a polyacetal resin, a polystyrene resin, a fluorine resin, or the like can be used as the tough resin film.

### A-2. Backsheet for photovoltaic module in second embodiment

Next, a backsheet for photovoltaic module in the second embodiment will be explained. The backsheet for photovoltaic module of the present embodiment comprises: a first hydrolysis-resistant film, a first gas barrier film having a first base film and a first gas-barrier layer formed thereon, a resin film, a second gas barrier film having a second base film and a second gas-barrier layer formed thereon, and a second hydrolysis-resistant film that are laminated in this order, characterized in that at least one of the first hydrolysis-resistant film and the second hydrolysis-resistant film is made of a polyester resin having a carboxy end-group content of 15 equivalent/ton or less, and the resin film is made of a polypropylene resin.

Hereinafter, the backsheet for photovoltaic module in the present embodiment will be described with reference to drawings. FIG. 5 is a schematic sectional view illustrating an example of the backsheet for photovoltaic module of the present embodiment. As exemplified in FIG. 5, the backsheet for photovoltaicmodule in the present embodiment has a configuration comprising a first hydrolysis-resistant film 21a, a first gas barrier film 25a, a resin film 22, a second gas barrier film 25b, and a second hydrolysis-resistant film 21b laminated in this order. In addition, the first gas barrier film 25a has a first base film 23a and a first gas-barrier layer 24a, while the second gas barrier film 25b has a second base film 23b and a second gas-barrier layer 24b.
Characteristically in the backsheet 14 for photovoltaic module in the present embodiment, at least one of the first hydrolysis-resistant film 21a and the second hydrolysis-resistant film 21b is made of a polyester resin having a carboxy end-group content of 15 equivalent/ton or less, and the resin film 22 is made of a polypropylene resin.

By using the backsheet for photovoltaic module of the present embodiment, it is possible to produce a backsheet for photovoltaic module superior in durability, in which at least one of the first and the second hydrolysis-resistant films is made of a polyester resin having a carboxy end-group content of 15 equivalent/ton or less and the resin film is made of a polypropylene resin superior in hydrolysis resistance. It is possible to obtain a backsheet for photovoltaic module more superior in moisture barrier characteristics, because the backsheet has two gas barrier films, i.e., the first and the second gas barrier films.
Hereinafter, the backsheet for photovoltaic module in such an embodiment will be described.

The first and second hydrolysis-resistant films, the first and second gas barrier films, and the resin film constituting the backsheet for photovoltaic module of the present embodiment are the same as the hydrolysis-resistant film, the gas barrier film, and the resin film described in the section of "A-1, Backsheet for photovoltaic module in the first embodiment", and thus, description thereof is omitted.

The combination of the first and second hydrolysis-resistant films used in the present embodiment is determined arbitrarily according to factors such as the durability required for the backsheet for photovoltaic module of the present embodiment. Accordingly, the first and the second hydrolysis-resistant films may be the same as or different from each other.
When the first and second hydrolysis-resistant films are different from each other, it means that the films are different not only in the kind of their constituting polyester resins, but also in configuration and function, specifically in film thickness and the kinds of the additives contained in the films.

The combination of the first and second gas barrier films used in the present embodiment is also determined arbitrarily according to factors such as the moisture barrier characteristics required for the backsheet for photovoltaic module of the present embodiment. Therefore, the first and the second gas barrier films may be the same as or different from each other.
When the first and second gas barrier films are different from each other, it means that the films are different not only in the kinds of the materials for the base film and the gas-barrier layer constituting the films, but also in configuration and function, specifically in film thickness and the kinds of the additives contained in the films.

The method of producing a backsheet for photovoltaic module of the present embodiment is not particularly limited, if it is a method of laminating the above-mentioned respective components efficiently. The dry lamination method described in the section of "A-1. Backsheet for photovoltaic module of first embodiment" may be used as the method of producing a backsheet for photovoltaic module in the present embodiment. The dry lamination method is the same as that described in the section of "A-1. Backsheet for photovoltaic module in first embodiment", and thus, the description thereof is omitted.

Other descriptions on the backsheet for photovoltaic module in the present embodiment are the same as those in the section of "A-1. Backsheet for photovoltaic module in first embodiment", and the descriptions thereof are omitted.

### B. Backside laminate for photovoltaic module

Hereinafter, the backside laminate for photovoltaic module of the present invention will be described. Characteristically, the backside laminate for photovoltaic module of the present invention has a backsheet for photovoltaic module in the first embodiment and an encapsulant for photovoltaic module laminated on the resin film of the backsheet for photovoltaic module.

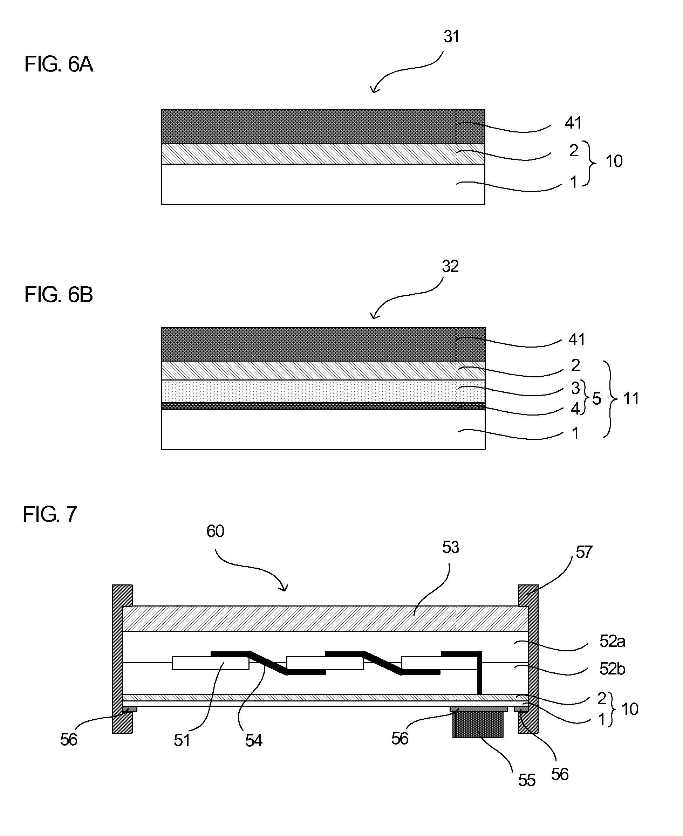

Hereinafter, the backside laminate for photovoltaic module of the present invention will be described with reference to drawings. FIGS. 6A and 6B are each a schematic sectional view illustrating an example of the backside laminate for photovoltaic module of the present invention. As shown in FIG. 6A, the backside laminate for photovoltaic module of the present invention 31 has: a backsheet 10 for photovoltaic module in the first embodiment of the present invention, i.e., a laminate of a hydrolysis-resistant film 1 and a resin film 2; and an encapsulant for photovoltaic module 41 formed on the resin film 2.
The backside laminate for photovoltaic module in the present embodiment employs the backsheet for photovoltaic module in the first embodiment of the present invention described above, and thus, for example as shown in FIG. 6B, it may have a configuration comprising a backsheet for photovoltaic module 11 containing a gas barrier film 5, and an encapsulant for photovoltaic module 41.

According to the present invention, it is possible to produce a backside laminate for photovoltaic module giving a photovoltaic module superior in durability, by using a backsheet for photovoltaic module having a hydrolysis-resistant film of the polyester resin having a carboxy end-group content of 15 equivalent/ton or less and a resin filmmade of the polypropylene resin film superior in hydrolysis resistance.

The backside laminate for photovoltaic module of the present invention has the firstbacksheet forphotovoltaicmodule of the first embodiment and the encapsulant for photovoltaic module. Hereinafter, each component for the backside laminate for photovoltaic module of the present invention will be described in detail.

### 1. Encapsulant for photovoltaic module

First, the encapsulant for photovoltaic module for use in the present invention will be described. The encapsulant for photovoltaic module for use in the present invention forms a backside encapsulant layer coating the photovoltaic during production of a photovoltaic module by using the backside laminate for photovoltaic module of the present invention.

The material for the encapsulant for photovoltaic module is not particularly limited, if it is a resin adhesive to the resin film of the backsheet for photovoltaic module, i.e., to the polypropylene resin. Examples of the resins include: fluorine resins ; ethylene-vinyl acetate copolymers ; ionomer resins ; silane-modified resins ; ethylene-acrylic acid or methacrylic acid copolymers ; polyethylene resins ; polypropylene resins ; acid-modifiedpolyolefin resins obtained by modifying a polyolefin resin such as polyethylene or polypropylene with an unsaturated carboxylic acid such as acrylic acid, itaconic acid, maleic acid, or fumaric acid; polyvinylbutyral resins ; silicone resins ; epoxy resins ; and (meth)acrylic resins. In the present invention, these resins may be used alone or as a mixture of two or more.

Particularly in the present invention, use of a silane-modified resin is preferable. It is because the silane-modified resin is superior in adhesiveness to the polypropylene resin constituting the resin film. Also in the present invention, among the silane-modified resins above, favorable is use of a thermoplastic silane-modified resin having a melting point in the range of 50°C to 200°C, more preferably in the range of 60°C to 180°C, and particularly preferably in the range of 65°C to 150°C. By using such thermoplastic silane-modified resin, it is possible to reduce relatively the temperature during thermocompression bonding and prevent, for example, the thermal damage on the hydrolysis-resistant film during production of a photovoltaic module by using the backside laminate for photovoltaic module of the present invention.

The thermoplastic silane-modified resin for use in the present invention is not particularly limited, if it has a melting point in the range above. In particular, the thermoplastic silane-modified resin for use in the present invention having a melt mass flow rate at 190°C of 0.5 to 10 g/10 minutes is preferable, and that of 1 to 8 g/10 minute is more preferable. It is because the resin improves the moldability of the encapsulant for photovoltaic module for use in the present invention.

Also in the present invention, a copolymer of a polyolefin compound and an ethylenically unsaturated silane compound is used favorably as the thermoplastic silane-modified resin. For example by using such copolymer, it becomes easier to adjust the various physical properties of the thermoplastic silane-modified resin according to factors such as the method of producing a backsheet for photovoltaic module of the present invention. It is because the copolymer of a polyolefin compound and an ethylenically unsaturated silane compound is also superior in adhesiveness to the polypropylene resin for the resin film. The copolymer according to the present invention may be crosslinked or may not be crosslinked by a silanol catalyst.

The copolymer for use in the present invention may be a random copolymer, an alternating copolymer, a block copolymer, or a graft copolymer. In the present invention, the copolymer is preferably a graft copolymer, more preferably a graft copolymer containing polyethylene as the polymer main-chain and an ethylenically unsaturated silane compound bound thereto as side-chains. It is because such a graft copolymer makes the freedom degree of the silanol group contributing to the adhesive strength and raises the adhesive strength of the encapsulant for photovoltaic module additionally.

Examples of the polyolefin compounds include homopolymers of an α-olefinic having about 2 to 8 carbon atoms, such as ethylene, propylene, or 1-butene; copolymers of the α-olefin and other α-olefins having about 2 to 20 carbon atoms such as ethylene, propylene, 1-butene, 3-methyl-1-butene, 1-pentene, 4-methyl-1-pentene, 1-hexene, 1-octene, and 1-decene; and copolymers thereof with vinyl acetate, (meth)acrylic acid, or a (meth)acrylic ester. Specific examples include ethylene homopolymers such as low-, medium- and high-density polyethylenes (branched or linear); ethylene resins such as ethylene-propylene copolymer, ethylene-1-butene copolymer, ethylene-4-methyl-1-pentene copolymer, ethylene-1-hexene copolymer, ethylene-1-octene copolymer, ethylene-vinyl acetate copolymer, ethylene-(meth)acrylate copolymer, and ethylene-ethyl (meth) acrylate copolymer; propylene resins such as propylene homopolymer, propylene-ethylene copolymer, and propylene-ethylene-1-butene copolymer; and 1-butene resins such as 1-butene homopolymer, 1-butene-ethylene copolymer, and 1-butene-propylene copolymer. Particularly in the present invention, polyethylene resins are preferable.

The polyethylene resin for use in the present invention (hereinafter, referred to as polyethylene for polymerization) is not particularly limited, if it is a polyethylene-based polymer. Examples of the polyethylene-based polymers include low-density polyethylenes, medium-density polyethylenes, high-density polyethylenes, very low-density polyethylenes, ultra low-density polyethylenes, and linear low-density polyethylenes. Also in the present invention, these polyethylene-based polymers may be used alone or as a mixture of two or more.

The polyethylene for polymerization for use in the present invention is preferably a polyethylene-based polymer having a lower density, and specifically, the density is preferably in the range of 0.850 g/cm³ to 0.960 g/cm³, particularly preferably in the range of 0.865 g/cm³ to 0.930 g/cm³. Polyethylene-based polymers having a lower density generally contain many side chains, and thus, are used favorably for graft polymerization. It is because, a density higher than the range above often results in insufficient graft polymerization, occasionally prohibiting provision of desired adhesive strength to the encapsulant for photovoltaic module. A density of lower than the range above often leads to deterioration in mechanical strength of the encapsulant for photovoltaic module.

As for the ethylenically unsaturated silane compound used in the present invention, it is not particularly limited as long as it is polymerized with the polyethylene for polymerization to form a thermoplastic silane-modified resin. For example, it is preferably at least one of the following: vinyltrimethoxysilane, vinyltriethoxysilane, vinyltripropoxysilane, vinyltributoxysilane, vinyltripentyloxysilane, vinyltriphenoxysilane, vinyltribenzyloxysilane, vinyltrimethylenedioxysilane, vinyltriethylenedioxysilane, vinypropionyloxysilane, vinyltriacetoxysilane, and vinyltricarboxysilane.

Hereinafter, the method of producing a graft copolymer of the polyolefin compound and the ethylenically unsaturated silane compound will be described. The method of producing the graft copolymer is not particularly limited, if it is a method giving a desired yield, and thus, the graft copolymer may be produced by any known polymerization means. Particularly favorable in the present invention is a method of obtaining a graft copolymer byheat-fusing and mixing a silane-modified resin composition containing the polyolefin compound, the ethylenically unsaturated silane compound, and a free radical initiator. This is because it is possible to obtain the graft copolymer at high yield by the method.

The heating temperature during the heat-fusion and mixing is not particularly limited, if it is in the range that the polymerization reaction is completed within a particular period of time. Normally, it is preferably 300°C or lower, more preferably 270°C or lower, and particularly preferably in the range of 160°C to 250°C. It is because a heating temperature lower than the range above may lead to insufficient polymerization reaction, while a heating temperature of higher than the range above may lead to crosslinking of the silanol groups and gelation of the polymer.

The free radical initiator is not particularly limited, if it is a compound effective in accelerating the polymerization reaction. Examples of the free radical initiator are organic peroxides, e.g. hydroperoxides such as diisopropylbenzene hydroxyperoxide and 2,5-dimethyl-2,5-di(hydroperoxy)hexane; dialkylperoxides such as di-tert-butyl peroxide, tert-butylcumyl peroxide, dicumyl peroxide, 2,5-dimethyl-2,5-di(tert-butylperoxy)hexane, and 2,5-dimethyl-2,5-di(tert-peroxy)hexyn-3; diacyl peroxides such as bis(3,5,5-trimethylhexanoyl)peroxide, octanoyl peroxide, benzoyl peroxide, o-methylbenzoyl peroxide, and 2,4-dichlorobenzoyl peroxide; peroxy esters such as tert-butylperoxy isobutyrate, tert-butylperoxy acetate, tert-butylperoxy-2-ethylhexanoate, tert-butylperoxypyvalate, tert-butylperoxy octoate, tert-butylperoxyisopropyl carbonate, tert-butylperoxy benzoate, di-tert-butylperoxy phthalate, 2,5-dimethyl-2,5-di(benzoylperoxy)hexane, and 2,5-dimethyl-2,5-di(benzoylperoxy)hexyn-3; and ketone peroxides such as methyl ethyl ketone peroxide and cyclohexanone peroxide; and azo compounds such as azobis(isobutyronitrile) and azobis(2,4-dimethylvaleronitrile). These free radical initiators may be used alone or by a mixture of two or more.

The content of the free radical initiator in the silane-modified resin composition may be determined arbitrarily according to the kind of the free radical initiator and the polymerization reaction condition. It is preferably in the range that leads to a residual amount thereof in the thermoplastic silane-modified resin obtained after polymerization reaction of 0.001 mass % or less. Normally in the present invention, it is preferably 0.001 wt part or more, particularly preferably 0.01 wt part to 5 wt parts, with respect to 100 wt parts of the polyolefin compound contained in the silane-modified resin composition.

The content of the ethylenically unsaturated silane compound in the silane-modified resin composition is preferably in the range of 0.001 wt part to 4 wt parts, particularlypreferably in the range of 0.01 wt part to 3 wt parts, with respect to 100 wt parts of the polyethylene for polymerization. It is because a content of the ethylenically unsaturated silane compound higher than the range may lead to insufficient polymerization and residual of free ethylenically unsaturated silane compound, while a content lower than the range above may lead to insufficient adhesiveness of the encapsulant for photovoltaic module.

The encapsulant for photovoltaic module of the present invention may contain as needed compounds other than the thermoplasticsilane-modifiedresin. In the present invention, a thermoplastic resin is preferably contained as the other compound, and in particular, apolyolefincompound (hereinafter, referred to polyolefin compound for addition) is preferably contained. When a copolymer of a polyolefin compound and an ethylenically unsaturated silane compound is used as the encapsulant for photovoltaic module, a polyolefin compound the same as the polyolefin compound used in the copolymer is preferably used as the polyolefin compound for addition.

In the present invention, the content of the polyolefin compound for addition in the encapsulant for photovoltaic module is preferably in the range of 0.01 wt part to 9,900 wt parts, more preferably in the range of 0.1 wt part to 2,000 wt parts, with respect to 100 wt parts of the thermoplastic silane-modified resin. A content of the polyolefin compound for addition lower than the range above may become disadvantageous from the point of cost, while a content larger than the range above may lead to insufficient adhesive strength of the encapsulant for photovoltaic module.

In the present invention, a polyethylene resin (hereinafter, referred to as polyethylene for addition) is preferably used as the polyolefin compound. It is because, in the present invention, a copolymer of a polyethylene resin and an ethylenically unsaturated silane compound is preferably used as the silane-modified resin.

The polyethylene for addition is preferably at least one resin selected from the group consisting of low-density polyethylenes, medium-density polyethylenes, high-density polyethylenes, very low-density polyethylenes, and linear low-density polyethylenes.

The polyethylene for addition is preferable to have a melt mass flow rate at 190°C in a range of 0.5 to 10 g/10 minutes and more preferable to have it in a range of 1 to 8 g/10 minutes. It is because the moldability or the like of the encapsulant layer for a photovoltaic module becomes excellent. A melting point of the polyethylene for addition is preferably 130°C or lower. The melting point is a value obtained with a melting point measurement method carried out by differential scanning calorimetry (DSC) according to the measurement method of transition temperature of plastics (JISK 7121). In this connection, when two or more melting points exist, the higher temperature is defined to be the melting point.

In the encapsulant for a photovoltaic module for the present invention, as needed, additives such as a light stabilizer, an ultraviolet absorbent, a heat stabilizer, or antioxidant may be used. By containing the above additive, the mechanical strength, prevention of yellowing, and prevention of cracking stable for a long period of time can be provided to the encapsulant for a photovoltaic module.

The light stabilizer is an agent for catching active species which initiate photo-deterioration in the encapsulant for a photovoltaic module and to prevent photooxidation. Specifically, a light stabilizer such as hindered amine type compounds, hindered piperidine type compounds, and others can be used.

The ultraviolet absorbent is an agent for absorbing harmful ultraviolet rays in the sun light and converting the ultraviolet rays into harmless heat energy in the molecules and accordingly preventing excitation of the active species which initiate photo-deterioration in the encapsulant for photovoltaic module. Specifically, inorganic type ultraviolet absorbents selected from a group of consisting of benzophenone type, benzotriazole type, salicylate type, acrylonitrile type, metal complex salt type, hindered amine type ultraviolet absorbents, ultra fine particles of titanium oxide (particle diameter: 0.01 µm to 0.06 µm), and ultra fine particles of zinc oxide (particle diameter: 0.01 µm to 0.04 µm) can be used.

Examples of the heat stabilizer may include phosphorus type thermal stabilizers such as tris(2,4-di-tert-butylphenyl)phosphite, bis[2,4-bis(1,1-dimethylethyl)-6-methylphenyl]ethyl ester phosphite, tetrakis(2,4-di-tert-butylphenyl)[1,1-biphenyl]-4,4'-diyl bisphosphonite, and bis(2,4-di-tert-butylphenyl)pentaerythritol disphosphite; and lactone type thermal stabilizers such as a reaction product of 8-hydroxy-5,7-di-tert-butyl-furan-2-one and o-xylene. Among them, it is preferable to use a phosphorus type thermal stabilizer and a lactone type thermal stabilizer in combination.

The antioxidant is added to prevent oxidative degradation of the encapsulant for photovoltaic module. Specific examples thereof include phenol-based, amine-based, sulfur-based, phosphorus-based, and lactone-based and other antioxidants.

These light stabilizers, ultraviolet absorbents, heat stabilizers and antioxidants may be used alone or in combination of two or more.

The content of the respective light stabilizer, ultraviolet absorbent, heat stabilizer or antioxidant may vary for example according to the particle shape and the density, but is preferably in the range of 0.001 mass % to 5 mass % in the encapsulant for photovoltaic module for use in the present invention.

Examples of the other compounds for use in the present invention include nucleating agent, crosslinking agent, dispersing agent, leveling agent, plasticizer, and antifoam.

The thickness of the encapsulant for photovoltaic module for use in the present invention is not particularly limited, if it is in the range allowing coating of the photovoltaic during production of the photovoltaic module. Normally, it is preferably in the range of 50 µm to 2000 µm, particularly preferably in the range of 10 µm to 200 µm. A thickness of the encapsulant for photovoltaic module smaller than the range above may prohibit desired adhesive strength, while a thickness larger than the range above demands excessive heating during production of the photovoltaic module, possibly causing greater thermal damage, for example, on the hydrolysis-resistant film.

The content of Si (silicon) in the encapsulant for photovoltaic module for use in the present invention is not particularly limited, if it is in the range giving favorable adhesiveness to the polyolefin resin constituting the resin film when a photovoltaic module is formed by using the backside laminate for photovoltaic module of the present invention. Especially in the present invention, the Si content in the encapsulant for photovoltaic module is preferably in the range of 8 ppm to 3,500 ppm, more preferably in the range of 10 ppm to 3,000 ppm, and particularly preferably in the range of 50 ppm to 2,000 ppm. It is because a Si content smaller than the range above leads to insufficient adhesiveness between the backside encapsulant layer and the backsheet when a photovoltaic module is formed by using the backside laminate for photovoltaic module of the present invention, prohibiting production of a photovoltaic module superior in temporal stability of adhesiveness. Alternatively, a Si content larger than the range above leads to increase in cost during production of the photovoltaic module by using the backside laminate for photovoltaic module of the present invention.
The polymerized Si is converted to SiO₂, as only the encapsulant for photovoltaic module is ashed by heating and combustion. Thus, the polymerized Si content is a value determined quantitatively by ICP emission spectroscopy, by dissolving the ash in purified water after alkali fusion, diluting it to a specific concentration, and measuring the polymerized Si content by using a high-frequency plasma emission analyzer (ICPS8100, manufactured by Shimadzu Corporation).

The gel fraction of the encapsulant forphotovoltaicmodule for use in the present invention is not particularly limited, if it is in the range that does not impair the thermomelting properties and the solvent solubility of the backside encapsulant layer after production of the photovoltaic module by using the encapsulant for photovoltaic module of the present invention. Particularly in the present invention, the gel fraction is preferably 30% or less, more preferably 10% or less, and particularly preferably 0%. A gel fraction of larger than the range above leads to insufficient thermomelting properties or solvent solubility during production of the photovoltaic module backside encapsulant layer by using the backside laminate for photovoltaic module of the present invention, possibly prohibiting sufficient recycling properties. The gel fraction is a value obtained by: (1) weighing the encapsulant for photovoltaic module in an amount of 1 g and placing it in a 80-mesh wire mesh bag, (2) placing the sample together with the wire mesh in a Soxhlet extractor and refluxing xylene at the boiling point, and (3) extracting the sample continuously for 10 hours, withdrawing and drying the sample with wire mesh, weighing it after treatment, and comparing the weight thereof before and after the processing, thus determining the mass % of the residual insoluble matter.

The density of the encapsulant for photovoltaic module for use in the present invention is preferably, approximately 0.890 g/cm³ to 0.935 g/cm³, more preferably approximately 0.890 g/cm³ to 0.930 g/m³, and most preferably in the range of 0.890 g/cm³ to 0.920 g/cm³. Because the average density of the polyethylene contained in the encapsulant for photovoltaic module is preferably in the particular range above as described above, the density of the entire photovoltaic module is preferably in the range above.
The density is a value determined by the density gradient method specified in JIS K7112. Specifically, it is a value obtained by placing a sample in a test tube containing liquids different in specific density and measuring the density by reading directly the position of the sample after equilibrium.

The encapsulant for photovoltaic module for use in the present invention preferably has high light transmittance. Specifically, the total light transmittance thereof is preferably in the range of 70% to 100%, more preferably in the range of 80% to 100%, and most preferably in the range of 90% to 100%.
The total light transmittance is determined by a common method, for example by a color computer.

The method of producing the encapsulant for photovoltaic module for use in the present invention is not particularly limited, if it is a method of producing an encapsulant for photovoltaic module having the various properties described above. In particular in the present invention, because the encapsulant for photovoltaic module preferably contains a silane-modified resin prepared by polymerization of an ethylenically unsaturated silane compound and a polyethylene for polymerization, an polyethylene for addition, and other additives as described above, it is preferably a method of producing an encapsulant for photovoltaic module, by preparing an encapsulant-forming composition by melting and mixing these components under heat and molding the encapsulant-forming composition.

In production of the encapsulant-forming composition, the method of mixing the silane-modified resin, the polyethylene for addition and the other additives is not particularly limited. The additives are preferably mixed by using an additive masterbatch in combination of these additives and polyethylene.

The masterbatch for addition is not particularly limited, if it contains the additives and polyethylene. Thus in the present invention, the additive masterbatch may contain a silane-modified resin, and it may also contain the polyethylene for addition.

The density of the polyethylene used in the additive masterbatch is preferably in the range of 0.890 g/cm³ to 0.930 g/cm³, more preferably in the range of 0.890 g/cm³ to 0. 928 g/cm³.

Preferably in the present invention, the additive masterbatch contains a polyethylene having a density in the range above; the average density of the polyethylene contained in the additive masterbatch is preferably in the range above; but the additive masterbatch may contain a relatively high-density polyethylene in an amount in the range that the average polyethylene density falls in the range above.
High-density polyethylenes are easily pulverized and thus superior in processability, allowing reduction in the cost. Accordingly, it is possible to reduce the production cost of the masterbatch by producing the masterbatch, by pulverizing a relatively high-density polyethylene into powder and mixing the powder of the relatively high-density polyethylene with a polyethylene having a density in the particular range above and additives.

The average density is an average of the values of the densities of the polyethylenes contained in the masterbatch multiplied respectively by the content rates.

The method of producing the encapsulant-forming composition by melting and mixing the additive masterbatch, the silane-modified resin, the polyethylene for addition and others under heat is not particularly limited. The heating temperature is preferably 300°C or lower, more preferably 270°C or lower, and particularly preferably 230°C or lower. Because the silane-modified resin easily gelates by crosslinking under heat in the silanol group part, the composition is preferably melted and mixed in the temperature range above.
The heating temperature when the composition is melted again under heat is preferably 300°C or lower, more preferably 270°C or lower, and particularly preferably 230°C or lower. Because the thermoplastic silane-modified resin described above easily gelates under heat in the silanol group part, the composition is preferably melted and extruded under heat in the temperature range above.

An encapsulant for photovoltaic module by molding the encapsulant-forming composition is produced, for example, by using a method of heat-melting the composition and extruding the melted composition by a traditional method such as T die or inflation method.

Alternatively in the present invention, a method of forming an encapsulant for photovoltaic module directly on the backsheet for photovoltaic module by melt-extruding the encapsulant-forming composition directly on the resin film of the backsheet for photovoltaic module described below may be used.

### 2. Backsheet for photovoltaic module

The backsheet for photovoltaic module part the present invention used in the backside laminate for photovoltaic module is the same as that described in the section of "A-1. Backsheet for photovoltaic module in first embodiment", and thus, description thereof is omitted.

### 3. Backside laminate for photovoltaic module

Hereinafter, the method of producing a backside laminate for photovoltaic module according to the present invention will be described. The method of producing the backside laminate for photovoltaic module is not particularly limited, if it is a method allowing lamination of the encapsulant for photovoltaic module on the resin film of the backsheet for photovoltaic module of the present invention. Examples of the methods include: a method of preparing the encapsulant for photovoltaic module and the backsheet for photovoltaic module separately and bonding them to each other, and a method of laminating the encapsulant for photovoltaic module on the resin film of the backsheet for photovoltaic module by casting.

### C. Photovoltaic module

Hereinafter, the photovoltaic module according to the present invention will be described. The photovoltaic module according to the present invention comprises a photovoltaic device, a front encapsulant layer and a backside encapsulant layer sandwiching the photovoltaic device in-between, a frontside transparent substrate laminated on the front encapsulant layer, and a backsheet laminated on the backside encapsulant layer, characterized in that the backsheet is the backsheet for photovoltaic module of the present invention described above.

The photovoltaic module according to the present invention will be described below with reference to drawings. FIG. 7 is a schematic sectional view illustrating an example of the photovoltaic module according to the present invention. As shown in FIG. 7, the photovoltaic module 60 according to the present invention has a configuration in which the photovoltaic devices 51 held between the front encapsulant layer 52a and the backside encapsulant layer 52b, a frontside transparent substrate 53 is formed on the front encapsulant layer 52a, and a backsheet for photovoltaic module according to the present invention 10 is formed on the backside encapsulant layer 52b.
In the photovoltaic module 60, individual photovoltaic devices 51 are connected to each other by wiring 54 for external discharge of the generated electric current, and the terminals of the wiring 54 are withdrawn out of the photovoltaic module through through-hole (not shown in the figure) formed in the backsheet for photovoltaic module according to the present invention 10 and are connected to a terminal box 55. The terminal box 55 is fixed and laminated with a silicone-based adhesive agent 56 on the hydrolysis-resistant film 1 constituting the backsheet for photovoltaic module according to the present invention 10.
In the photovoltaic module 60 according to the present invention, a metal frame 57 may be used for casing. In such a case too, the frame is installed with a silicone adhesive agent 56, similarly to the terminal box 55.

According to the present invention, it is possible to produce a photovoltaic module superior in durability, by using a backsheet for photovoltaic module having the hydrolysis-resistant film of a polyester resin having a carboxy end-group content of 15 equivalent/ton or less and the resin film of a polypropylene resin film superior in hydrolysis resistance.

The photovoltaic module according to the present invention has a photovoltaic device, front and backside encapsulant layers, a frontside transparent substrate and a backsheet. Hereinafter, each component of the photovoltaic module according to the present invention will be described separately in detail.
The backsheet used in the photovoltaic module according to the present invention is the same as that described in the section of "A. Backsheet for photovoltaic module", and thus, description thereof is omitted.

### 1. Front and backside encapsulant layers

The materials for the front and backside encapsulant layers used in the photovoltaic module according to the present invention are the same as those for the encapsulant for photovoltaic module described in the section of "B. backside laminate for photovoltaic module", and descriptions thereof are omitted.

In the present invention, the gel fractions of the front and backside encapsulant layers are respectively, preferably 30% or less, more preferably 10% or less, and particularly preferably 0%. A gel fraction larger than the range above may impair the recycling properties of the photovoltaic module having the encapsulant for photovoltaic module layer according to the present invention. The gel fraction is a value obtained by: (1) weighing 1 g of the encapsulant layer and placing it in a 80-mesh wire mesh bag, (2) extracting the sample with xylene in a Soxhlet extractor under reflux at the boiling point, (3) withdrawing, drying and weighing the sample with wire mesh after continuous 10 hours, comparing the weights before and after extraction, and measuring the mass % of the residual insoluble matter.

The front and backside encapsulant layers for use in the present invention, which have a function to bond the photovoltaic devices described below to the frontside transparent substrate and also to the backsheet, are preferably more adhesive to the frontside transparent substrate and the backsheet. Specifically, the peeling strength of the encapsulant layers off the frontside transparent substrate and back surface protective sheet, which are measured in a 180° peel test under a 25°C atmosphere, are preferably in the range of 1 to 150 N/15 mm width, more preferably in the range of 3 to 150 N/15 mm width and most preferably in the range of 10 to 150 N/15 mm width.
The peel strength is a value obtained by a test method below.
Test machine: Tensile tester manufactured by A & D CO., Ltd. (trade name: TENSION^{®})
Measurement angle: 180° peeling
Peeling rate: 50 mm/min

The peel strength of each of the front encapsulant layer and the backside encapsulant layer off the frontside transparent substrate or backsheet, which is measured in a 180° peel test under a 25°C atmosphere after a photovoltaic module is left in a high temperature and high humidity state of a temperature of 85°C and humidity of 85% for 1000 hours, is preferably in the range of 0.5 to 140 N/15 mm width, more preferably in the range of 3 to 140 N/15 mm width, and most preferably in the range of 10 to 140 N/15 mm width.
The measurement method is similar to that mentioned above.

A thickness of each of the front encapsulant layer and the back side encapsulant layer is not particularly limited if it is within the rage which can cover the photovoltaic device described below. Normally, it is in the range of 50 to 2000 µm and particularly preferably in the range of 100 to 1250 µm. When the thickness of the encapsulant layer is thinner than the above range, there is a risk that the front encapsulant layer and/or the backside encapsulant layer may not be able to cover the photovoltaic device. When the thickness is thicker than the above range, the photovoltaic module weight becomes heavy to be poor in the workability at the setting and also the cost becomes disadvantageous.

Further, the front and the backside encapsulant layers preferably have high light transmittance. Specifically, the total light transmittance thereof is preferably in the range of 70% to 100%, more preferably in the range of 80% to 100%, and most preferably in the range of 90% to 100%.

### 2. Frontside transparent substrate

The frontside transparent substrate for use in the present invention is not particularly limited, if it is a substrate transmitting sunlight. Examples thereof include glass plates and various resin films such as of a fluorine resin, a polyamide resin (various nylon), a polyester resin, a polyethylene resin, a polypropylene-based resin, a cyclic polyolefin resin, a polystyrene resin, a (meth) acrylic resin, a polycarbonate resin, an acetal resin, and a cellulosic resin.
The thickness of the frontside transparent substrate for use in the present invention is not particularly limited, if the substrate has desired strength, and preferably in the range of 12 µm to 200 µm, particularly preferably in the range of 25 µm to 150 µm in the case of resin film, and preferably in the range of 0.5 to 5 mm in the case of a glass plate.

### 3. Photovoltaic device

A photovoltaic device used in the invention is not particularly restricted, and one that is generally used as a photovoltaic device may be used. Examples thereof include crystalline silicon photovoltaic devices such as a single crystal silicon photovoltaic device and a polycrystalline silicon photovoltaic device, amorphous silicon photovoltaic devices made of single connection type or tandem structure type, photovoltaic devices of III-V group compound semiconductors such as gallium arsenide (GaAs) and indium phosphide (InP), photovoltaic devices of II-VI group compound semiconductors such as cadmium telluride (CdTe) and copper indiumselenide (CuInSe₂), and an organic photovoltaic device.

A thin-film polycrystalline silicon photovoltaic device, a thin-film microcrystalline silicon photovoltaic device, or a hybrid element of a thin-film crystalline silicon photovoltaic device and an amorphous silicon photovoltaic device may be used as the photovoltaic device for use in the present invention.

### 4. Others

The photovoltaic module according to the present invention may contain other laminated layers arbitrarily, for improvement in sunlight-absorbing efficiency, reinforcement, and others. The other layer may be used as it is selected arbitrarily from films and sheets of known resins such as low-density polyethylenes, medium-density polyethylenes, high-density polyethylenes,linearlow-density polyethylenes,polypropylene, ethylene-propylene copolymers, ethylene-vinyl acetate copolymers, ionomer resins, ethylene-ethyl acrylate copolymers, ethylene-acrylic acid or methacrylic acid copolymers, methylpentene polymers, polybutene resins, polyvinyl chloride resins, polyvinyl acetate resins, polyvinylidene chloride resins, vinyl chloride-vinylidene chloride copolymers, poly(meth)acrylic resins, polyacrylonitrile resins, polystyrene resins, acrylonitrile-styrene copolymers (AS resins), acrylonitrile-butadiene-styrene copolymers (ABS resins), polyester resins, polyamide resins, polycarbonate resins, polyvinylalcohol resins, saponified material of ethylene-vinyl acetate copolymers, fluorine resins, diene resins, polyacetal resins, polyurethane resins, and nitrocellulose.

The photovoltaic module according to the present invention preferably has a terminal box installed on the backsheet for photovoltaic module. It is possible to make the photovoltaic module according to the present invention higher in practical performance, by installing the terminal box thereon.

The terminal box is preferably bonded with an adhesive agent onto the hydrolysis-resistant film constituting the backsheet for photovoltaic module. It is because presence of the terminal box bonded onto the hydrolysis-resistant film with an adhesive agent increases the adhesiveness of the terminal box thereto.

The terminal box for use in the present invention is not particularly limited, and any common terminal box used in photovoltaic modules may be used.

The adhesive agent is not particularly limited, if it is effective in bonding the adhesion part to the terminal box. Particularly in the present embodiment, the adhesive agent for use is preferably a silicone-based, modified silicone-based, polysulfide-based, acryl urethane-based, polyurethane-based, modified polysulfide-based, acrylic, SBR-based, or butyl rubber-based oily caulking agent. In particular in the present invention, the adhesive agent for use is preferably a silicone-based adhesive agent. Silicone-based adhesive agents are superior in waterproofing efficiency. In addition, the silicone-based adhesive agents are widely used in the construction material and other applications, and are superior in flexibility in use and thus easily applicable to the present invention.

Further in installing the terminal box, an adhesion part may be formed in the part for installation of the terminal box provided on the hydrolysis-resistant film constituting the backsheet for photovoltaic module. It is because the adhesion part thus formed, which improves the adhesive strength between the adhesive agent and the backsheet, enables tighter installation of the terminal box.

Preferably a thermally adhesive thermoplastic resin is used as the material for the adhesion part.

When a metal frame is used to enclose the photovoltaic module according to the present invention, the metal frame used is normally an aluminum frame. The size, shape and other factors of the metal frame are not particularly limited, and are selected properly for example according to the application of the photovoltaic module of the present invention.

### 5. Method of producing photovoltaic module

Hereinafter,the methodofproducing a photovoltaic module according to the present invention will be described. The method of producing a photovoltaic module according to the present invention is not particularly limited, if it is a method giving a photovoltaic module in the configuration above, and any common method may be used. For example, a common molding method of laminating a frontside transparent substrate, an encapsulant for photovoltaic module, photovoltaic devices, an encapsulant for photovoltaic module, a backsheet, and others sequentially and then, bonding them as a whole by thermocompression bonding under vacuum may be used as the method. A photovoltaic module having the respective layers molded integrally is obtained by such a method.

Alternatively, for example, a commonly molding method of laminating a frontside transparent substrate, an encapsulant for photovoltaic module, photovoltaic devices, and the backside laminate for photovoltaic module according to the present invention sequentially and bonding them as a whole by thermocompression bonding under vacuum may be used as the method of producing a photovoltaic module in the present embodiment.

The laminate temperature when the lamination method is used is preferably in the range of 90°C to 230°C, more preferably in the range of 110°C to 190°C. Alternatively, the laminate period is preferably in the range of 5 to 60 minutes, more preferably in the range of 8 to 40 minutes.

It should be understood that the present invention is not restricted by the embodiments above. The embodiments above are nothing but examples, and those in a configuration substantially similar to that based on the technological idea described in the claims of the present invention and having similar operational advantages are also included in the scope of the present invention.

### EXAMPLES

Hereinafter, the present invention will be described more specifically with reference to Examples.

The carboxy end-group content, the intrinsic viscosity, and the oligomer content of the hydrolysis-resistant films used in Examples and Comparative Examples were determined by the following methods, unless specified otherwise.

### <Measurement of terminal carboxyl group amount>

Dissolved in o-cresol was 0.5 g of the polymer extracted fromahydrolysis-resistant film, and the terminal carboxyl group amount was determined by potentiometric titration with potassium hydroxide.

### <Measurement of intrinsic viscosity>

The viscosity of a solution containing the polymer extracted from a hydrolysis-resistant film in ortho chlorophenol at a concentration of 0.1 g/ml was determined at 25°C.

### <Measurement of oligomer content>

Dissolved in 2 ml of ortho chlorophenol was 100 mg of the polymer extracted from a hydrolysis-resistant film, and the oligomer content was determined by analyzing the solution by liquid chromatography (HLC803D, manufactured by Toso Sangyo Co. Ltd.) and expressed as the oligomeric rate (mass %) with respect to the polymer.

### (Example 1)

### 1. Preparation of hydrolysis-resistant film

Placed were 100 parts of dimethyl terephthalate, 70 parts of ethylene glycol, and 0.09 part of calcium acetate monohydrate and they were heated in a reactor gradually to 240°C over about 4 hours after initiation of the reaction, allowing ester ester-exchange reaction and distilled methanol away, until the ester-exchange reaction is substantially complete. The reaction mixture then was transparent, and the calcium compound remained dissolved. Then, a solution containing 0.175 part of triethyl phosphate and 0.040 part of trimethyl phosphite dissolved in 2.2 parts of ethylene glycol was added to the ester-exchange reaction product.

Subsequently, 0.04 part of antimony trioxide was added as polymerization catalyst, and the mixture was polymerized by a common method. Specifically, the temperature of the system was changed to 280°C and the pressure to 15 mm Hg, 100 minutes after addition of antimony trioxide and the pressure is reduced gradually, finally to 0.3 mm Hg. After 4 hours, the system was brought back to normal pressure, and the polymer was extruded, to give a polyethylene terephthalate sample having an intrinsic viscosity of 0.51 dl/g. The polyethylene terephthalate was molded into chips, and subjected to solid-phase polymerization in a rotating vacuum polymerization apparatus under a reduced pressure of 0.3 mm Hg and at 230°C while the period was adjusted properly, to give a polymer having an intrinsic viscosity of 1.4 dl/g. A copolymer of p-hydroxybenzoic acid (80 mol %) and ethylene terephthalate (20 mol %) (liquid-crystal initiation temperature: 240°C, melting point: 260°C, melt viscosity: 500 poises) was used as the liquid-crystal polyarylate. The mixture of the 95 mass % of PET and the 5 mass % of PA after drying and dehydration was supplied into and melted in a known 150-mm extruder at 285°C and extrusion-molded through the T die onto a cooling drum kept at 25°C, where it was solidified rapidly by cooling in contact while static electricity was applied thereto. The cast film obtained was stretched three times in the longitudinal direction in a roll stretching machine at 95°C. The film was then processed by heat setting in a tenter, while stretched 3.5 times in the width direction and then relaxed by 5% in the width direction at 235°C, to give a biaxially oriented hydrolysis-resistant polyester film having a thickness of 50 µm.

Subsequently, the hydrolysis-resistant polyester film was subjected to heat shrinkage treatment, while it is conveyed at a velocity of 30 m/min through a drying oven having an oven length of 12 m that is kept at 150°C with hot air circulating at a flow rate of 10 m/sec, to give a film having a shrinkage rate of -0.3% in the flow direction and-0.1% in the width direction. In addition, both faces of the hydrolysis-resistant polyester film after heat shrinkage were subjected to corona discharge treatment by a common method, forming corona-treated surfaces.

As for the measured properties of the film obtained, the intrinsic viscosity was 1.25 dl/g; the oligomer content, 0.30 mass %; and the carboxyl end-group content, 12 equivalent/ton.

### 2. Preparation of resin film

A whitener titanium oxide (5 mass %), ultrafine titanium oxide particles (particle diameter: 0.01 to 0.06 µm, 3 mass %) as an ultraviolet absorbent, benzophenone-based ultraviolet absorbent (1 mass %) as another ultraviolet absorbent, and a hindered amine-based light stabilizer (1 mass %) as a light stabilizer were added to a polypropylene resin; other desirable additives were added thereto; and the mixture was blended thoroughly, to give a polypropylene resin composition. Subsequently, the polypropylene resin composition was melt-extruded and molded by a T die extruder, into a white unstretched polypropylene resin film having a thickness of 120 µm. In addition, both faces of the white unstretched polypropylene resin film were subjected to corona discharge treatment by a common method, forming corona-treated surfaces.

### 3. Preparation of backsheet for photovoltaic module

A polyester-based adhesive agent was coated on one corona-treated surfaces of the hydrolysis-resistant polyester film having a thickness of 50 µm prepared by the method above, by gravure roll coating method to a layer thickness of 5.0 g/m² (dry state), to give an adhesive layer for lamination after drying.
Subsequently, the resin film prepared above is placed on the adhesive agent layer for lamination thus formed with the one corona-treated surface facing it and then, the hybrid was dry-laminated, to give a backsheet for photovoltaic module according to the present invention.

### 4. Preparation of encapsulant sheet for photovoltaic module

### (1) Preparation of silane-modified resin

A linear low density polyethylene (LLDPE) having a density of 0.898 g/cm³ and a melt mass flow rate (MFR) at 190°C of 2 g/10 minutes of 98 parts by weight was mixed with vinyltrimethoxysilane of 2 parts by weight and as a radical initiator, dicumyl peroxide of 0.1 part by weight and heated, melted, and stirred at 200°C to obtain a silane-modified resin.

### (2) Formation of encapsulant sheet for photovoltaic module

The above-mentioned silane-modified resin of 5 parts by weight, a linear low density polyethylene having a density of 0.898 g/cm³ of 95 parts by weight, and a separately produced a master batch containing a light resistant agent, UVA, and an antioxidant (obtained by mixing a hindered amine type light stabilizer of 2.5 parts by weight, a benzophenone type ultraviolet absorbent of 7.5 parts by weight, and a phosphorus type thermal stabilizer of 5 parts by weight with a linear low density polyethylene of 85 parts by weight and the mixture was melted and processed to be pellets) of 5 parts by weight were mixed and led to a hopper of a film molding apparatus having a φ25 mm extruder and a T die with 300 mm width and formed into a 600 µm-thick sheet at drawing speed of 2.5 m/min and at 230°C extrusion temperature. The film formation was carried out without any problem. An encapsulant layer for a photovoltaic module was thus obtained through the series of the processes.

### 5. Preparation of photovoltaic module

By using the backsheet for photovoltaic module prepared by the method, a glass plate having a thickness of 3 mm, the encapsulant sheet thus prepared having a thickness of 600 µm, cell strings of multiple single-crystalline Si-based photovoltaic devices connected to each other with lead wires, and the encapsulant sheet prepared above having a thickness of 600 µm, and the backsheet for photovoltaic module were integrated at 150°C for 15 minutes under heat and vacuum, with the surfaces of respective polypropylene resin films facing each other; and cuts for withdrawing the lead wire parts on the side of the backsheet are preliminary formed in the backsheet and the encapsulant sheet for backsheet, thus exposing the lead wires out of the backsheet; and then, the end parts were covered with a sealing material of a silicone rubber and an aluminum frame.
For installation of the terminal box for connection of the lead wires connecting photovoltaic devices, a silicone-based adhesive agent was coated on the backsheet to a thickness 0.5 to 1 mm after adhesion of the terminal box adhesion, and then the terminal box was connected thereto. Then, the lead wires and the terminal part were connected to each other for example by soldering, and the terminal box was filled with a silicon-based potting agent and left in air for one day, to give a photovoltaic module.

### (Example 2)

### 1. Preparation of hydrolysis-resistant film, resin film, and encapsulant sheet for photovoltaic module

A hydrolysis-resistant film, a resin film, and an encapsulant sheet for photovoltaic module were prepared by a method similar to Example 1.

### 2. Preparation of gas barrier film

A biaxially stretched polyethylene terephthalate film carrying corona-treated surfaces formed on both faces having a thickness of 12 µm was used as the gas barrier film; the film is placed on the delivery roll of a plasma-enhanced chemical vapor deposition apparatus; and a vapor-deposition film of silicon oxide having a thickness of 800 Ǻ (80 nm) was formed on one corona-treated surface of the biaxially stretched polyethylene terephthalate film under the following condition:

### (Vapor deposition condition)

Reaction gas blending ratio: hexamethyl disiloxane: oxygen gas: helium: 1:10:10 (unit: slm)
Vacuum in vacuum chamber: 5.0×10⁻⁶ mbar
Vacuum in vapor deposition chamber: 6.0×10⁻² mbar
Power supplied to cooling and electrode drums: 20kW
Traveling speed of film: 80 m/minute

### 3. Preparation of backsheet for photovoltaic module

A polyester-based adhesive agents was coated on one corona-treated surface of the hydrolysis-resistant polyester film having a thickness of 50 µm prepared by the method above, by gravure roll coating to a layer thickness of 5.0 g/m² (dry state), to form an adhesive layer for lamination after drying.
Subsequently, the biaxially stretched polyethylene terephthalate film having a vapor-deposition silicon oxide having a thickness of 800 Ǻ prepared above formed on the face of the adhesive agent layer for lamination obtained was placed on the surface of the adhesive agent layer for lamination thus formed, with its surface of the vapor-deposition silicon oxide film facing it, and the composite was then dry-laminated.
Further subsequently, a polyester-based adhesive agent was coated on the corona-treated surface of the biaxially stretched polyethylene terephthalate film carrying the dry-laminated vapor-deposition silicon oxide film having a thickness of 800 Ǻ, similarly to above, by gravure roll coating to a layer thickness of 5.0 g/m² (dry state), to form an adhesive layer for lamination after drying.
It was then placed on the surface of the adhesive agent layer for lamination thus formed, with one corona-treated surface of the resin film prepared above facing the surface, to give a backsheet for photovoltaic module.

### 4. Preparation of photovoltaic module

Subsequently, a photovoltaic module was prepared in a similar manner to the method described in the section of "Preparation of photovoltaic module" in Example 1 by using the backsheet for photovoltaic module prepared by the method above.

### (Example 3)

### 1. Preparation of hydrolysis-resistant film, resin film, and encapsulant sheet for photovoltaic module

A hydrolysis-resistant film, a resin film, and an encapsulant sheet for photovoltaic module were prepared by a method similar to Example 1.

### 2. Preparation of gas barrier film

A gas barrier film was prepared by a method similar to Example 2.

### 3. Preparation of backsheet for photovoltaic module

A polyester-based adhesive agents was coated on one corona-treated surface of the hydrolysis-resistant polyester film having a thickness of 50 µm prepared by the method above, by gravure roll coating to a layer thickness of 5.0 g/m² (dry state), to form an adhesive layer for lamination after drying.
Subsequently, the biaxially stretched polyethylene terephthalate film carrying the vapor-deposition silicon oxide film having a thickness of 800 Ǻ prepared above was placed on the surface of the adhesive agent layer for lamination thus formed, with its vapor-deposition silicon oxide film facing it, and the composite was dry-laminated.
Further subsequently, a polyester-based adhesive agent was coated on the corona-treated surface of the biaxially stretched polyethylene terephthalate film carrying the dry-laminated vapor-deposition silicon oxide film having a thickness of 800 Ǻ, similarly to above, by gravure roll coating to a layer thickness of 5.0 g/m² (dry state), to form an adhesive layer for lamination after drying.
Following to the above, the biaxially stretched polyethylene terephthalate film prepared above carrying a vapor-deposition silicon oxide film having a thickness of 800 Ǻ on the surface of the adhesive agent layer for lamination prepared above was placed on the surface of the adhesive agent layer for lamination thus formed, with its surface of the vapor-deposition silicon oxide film facing it, and the composite was dry-laminated.
It was then placed on the surface of the adhesive agent layer for lamination thus formed, with one corona-treated surface of the resin film prepared above facing the surface, to give a backsheet for photovoltaic module.

### 4. Preparation of photovoltaic module

Subsequently, a photovoltaic module was prepared in a similar manner to the method described in the section of "Preparation of photovoltaic module" in Example 1 by using the backsheet for photovoltaic module prepared by the method above.

### (Example 4)

### 1. Preparation of hydrolysis-resistant film, resin film, and encapsulant sheet for photovoltaic module

A hydrolysis-resistant film, a resin film, and an encapsulant sheet for photovoltaic module were prepared by a method similar to Example 1.

### 2. Preparation of gas barrier film

A gas barrier film was prepared by a method similar to Example 2.

### 3. Preparation of backsheet for photovoltaic module

A polyester-based adhesive agents was coated on one corona-treated surface of the hydrolysis-resistant polyester film having a thickness of 50 µm prepared by the method above, by gravure roll coating to a layer thickness of 5.0 g/m² (dry state), to form an adhesive layer for lamination after drying.
Subsequently, the biaxially stretched polyethylene terephthalate film carrying the vapor-deposition silicon oxide film having a thickness of 800 Ǻ prepared above was placed on the surface of the adhesive agent layer for lamination thus formed, with its vapor-deposition silicon oxide film facing it, and the composite was dry-laminated.
Further subsequently, a polyester-based adhesive agent was coated on the corona-treated surface of the biaxially stretched polyethylene terephthalate film carrying the thus dry-laminated vapor-deposition silicon oxide film having a thickness of 800 Ǻ, similarly to above, by gravure roll coating to a layer thickness of 5.0 g/m² (dry state), to form an adhesive layer for lamination after drying.
The resin film was then placed on the surface of the adhesive agent layer for lamination thus formed with its corona-treated surface facing it, and then, the composite was dry-laminated. Subsequently, a polyester-based adhesive agent was coated on the other corona-treated surface of the thus dry-laminated resin film similarly to above, by gravure roll coating to a layer thickness of 5.0 g/m² (dry state), to form an adhesive layer for lamination after drying.
Subsequently, a common industrial polyester film corona-treated on both faces was placed on the surface of the adhesive agent layer for lamination thus formed, with a corona-treated surface of the resin film thus obtained facing it, to give a backsheet for photovoltaic module according to the present invention.

### 4. Preparation of photovoltaic module

Subsequently, a photovoltaic module was prepared in a manner similar to that described in the section of "Preparation of photovoltaic module" in Example 1, by using the backsheet for photovoltaic module prepared above.

### (Example 5)

A photovoltaic module was prepared in a similar manner to Example 3, except that an encapsulant sheet for photovoltaic module and an ethylene-vinyl acetate copolymer sheet for photovoltaic having a thickness of 600 µm were used.

### (Example 6)

A photovoltaic module was prepared in a similar manner to Example 4, except that an encapsulant sheet for photovoltaic module and an ethylene-vinyl acetate copolymer sheet for photovoltaic having a thickness of 600 µm were used.

### (Comparative Example 1)

### 1. Preparation of gas barrier film

A gas barrier film was prepared in a similar manner to Example 2.

### 2. Preparation of backsheet for photovoltaic module

A polyester-based adhesive agent was coated by a common method on one corona-treated surface of a common industrial PET film having a thickness of 50 µm that was corona-treated on both faces, by gravure roll coating to a layer thickness of 5.0 g/m² (dry state), to form an adhesive layer for lamination after drying.
Subsequently, the biaxially stretched polyethylene terephthalate film carrying the vapor-deposition silicon oxide film having a thickness of 800 Ǻ prepared above was placed on the surface of the adhesive agent layer for lamination thus formed with its surface of the vapor-deposition silicon oxide film facing it, and the composite was dry-laminated.
Subsequently, a polyester-based adhesive agent was coated on the corona-treated surface of the biaxially stretched polyethylene terephthalate film carrying the thus dry-laminated vapor-deposition silicon oxide film having a thickness of 800 Ǻ, similarly to above, by gravure roll coating, to a layer thickness of 5.0 g/m² (dry state), to form an adhesive layer for lamination after drying.
Subsequently, the biaxially stretched polyethylene terephthalate film carrying the vapor-deposition silicon oxide film prepared above having a thickness of 800 Ǻ on the surface of the adhesive agent layer for lamination prepared above was placed on the surface of the adhesive agent layer for lamination thus formed, with its surface of the vapor-deposition silicon oxide film facing it, and the composite was dry laminated.
Subsequently, a common industrial PET film having a thickness of 125 µm that was corona-treated on both faces by a common method was placed on the surface of the adhesive agent layer for lamination thus formed with its corona-treated surface facing it, to give a backsheet for photovoltaic module.

### 3. Preparation of photovoltaic module

A photovoltaic module was prepared in a method similarly to that described in the section of "Preparation of photovoltaic module" in Example 1 as the ethylene-vinyl acetate copolymer sheet for photovoltaic having a thickness of 600 µm, by using the backsheet for photovoltaic module prepared by the method above. The photovoltaic module prepared was found to be unfavorable in backside appearance, because of protrusion of the lead wire due to shortening of the distance between cells under the influence of the backsheet inferior in shrinkage rate.

### (Comparative Example 2)

### 1. Preparation of hydrolysis-resistant film

The polyethylene terephthalate having an intrinsic viscosity of 0.51 dl/g used in preparation of the hydrolysis-resistant films of Examples 1 to 6 was subjected to solid-phase polymerization for a different period of time, to give a polyethylene terephthalate polymer having an intrinsic viscosity of 0.64 dl/g. Separately, a biaxially-oriented hydrolysis-resistant polyester film was prepared in a similar manner to Examples 1 to 6, except that the polyarylate added in Example 1 was eliminated. As for the properties of the film obtained, the intrinsic viscosity was 0.65 dl/g; the oligomer content, 1.29 mass %; and the carboxyl end-group content, 34 equivalent/ton.

### 2. Preparation of photovoltaic back sheet and photovoltaic module

A photovoltaic back sheet, and then, a photovoltaic module were prepared in a similar manner to Example 3, by using the hydrolysis-resistant film prepared by the method above.

### (Comparative Example 3)

### 1. Preparation of hydrolysis-resistant film

The polyethylene terephthalate having an intrinsic viscosity of 0.51 dl/g used in preparation of the hydrolysis-resistant films of Examples 1 to 6 was subjected to solid-phase polymerization for a different period of time, to give a polyethylene terephthalate polymer having an intrinsic viscosity of 1.41 dl/g. Separately, a biaxially-oriented hydrolysis-resistant polyester film was prepared in a similar manner to Examples 1 to 6, except that the polyarylate added in Example 1 was added this time by 0.06 mass %. As for the properties of the film obtained, the intrinsic viscosity was 0.81 dl/g; the oligomer content, 0.66 mass %; and the carboxyl end-group content, 21 equivalent/ton.

### 2. Preparation of photovoltaic back sheet and photovoltaic module

A photovoltaic back sheet, and then, a photovoltaic module were prepared in a similar manner to Example 3, by using the hydrolysis-resistant film prepared by the method above.

### (Evaluation)

Determined were: (1) The steam permeability (retention), (2) the rate of diminution in output, (3) the adhesion strength to encapsulant material (retention), (4) the interlayer adhesion strength (retention), and (5) the breaking strength of backsheet after pressure cooker test of the backsheets for photovoltaic module obtained in Examples and Comparative Examples above. The results are summarized in Table 1.

### (1) Measurement of steam permeability (retention)

A photovoltaic backsheet was subjected to an environmental test at a temperature of 85°C and a humidity of 85% for 1000 hr, and the steam permeability thereof after the environmental test was determined under the condition of a temperature of 40°C and a humidity of 90% RH by using an analyzer (product name: PERMATRAN) manufactured by MOCON Inc. Measurement was performed before and after the test.

### (2) Measurement of the shrinkage rate of backsheet

According to the Testing methods of plastic films for electrical purposes specified in JIS C2151 the backsheet was cut into pieces of 100x100 mm in size; the dimensions of the test piece before and after heating in a dry oven at 150°C for 30 minutes were determined at an accuracy of 0.1 mm both in the film flow direction and in the width direction, to give shrinkage rates.

### (3) Measurement of the rate of diminution in output

A photovoltaic module was subjected to an environmental test (temperature: 85°C, humidity: 85%, 1,000 hr) according to the method of JIS C8917-1989, and the photoelectromotive force outputs before and after the test were determined and compared for evaluation.

### (4) Measurement of adhesion strength to encapsulant material (retention)

According to the method specified in JIS C8917-1989, a photovoltaic module was subjected to an environmental test (temperature: 85°C, humidity: 85%, 1,000 hr), the adhesion strength to the encapsulant material after the environmental test was determined by cutting the photovoltaic module to strips of 15 mm in width and measuring the adhesion strength thereof between the backsheet and the encapsulant by using a tensile tester (product name: TENSILON®, manufactured by A & DCO., Ltd.).

### (5) Breaking strength after pressure cooker test

A backsheet for photovoltaic was cut into pieces of 15 mm x 30 mm, and the breaking strength of the base material was determined by using a tensile tester (product name: TENSILON^{®}, manufactured by A & D CO., Ltd.). As for the test method, a sample was treated in an accelerated test in a pressure cooker (manufactured by HIRAYAMA MANUFACTURING CORPORATION) under the condition of 120°C, 85% and 1.6 atmospheres for 72 hours, and the breaking strengths before and after the test were determined.

### (6) Evaluation of the adhesion state of terminal box

A photovoltaic module prepared was subjected to an environmental test at 85°C and 85% for 1000 hours, and then, the adhesion state of the terminal box was examined. A wiring cable is connected to the terminal box of a photovoltaic module, and the adhesion state of the terminal box was evaluated, while the module was lifted only with the cable.

**[Table 1]**

| | Steam permeability (g/m2/day) | | Rate of diminution in output (%) | Adhesion strength to encapsulant material (N/15 mm) | | Breaking strength (N/15mm) | | | Shrinkage rate (%) | | Adhesion state of terminal box |
|---|---|---|---|---|---|---|---|---|---|---|---|
| | Before Test | After Test | | Before Test | After Test | Before Test | After Test | Retention rate | Flow direction | Width direction | |
| Example 1 | 1.23 | 1.25 | 3.3 | 76 | 60 | 240 | 158 | 65% | 0.3 | 0.1 | Favorable |
| Example 2 | 0.22 | 0.25 | 2.3 | 70 | 65 | 260 | 165 | 63% | 0.3 | 0.1 | Favorable |
| Example 3 | 0.05 | 0.08 | 1.8 | 72 | 68 | 265 | 167 | 63% | 0.3 | 0.1 | Favorable |
| Example 4 | 0.04 | 0.07 | 1.8 | 65 | 40 | 305 | 195 | 74% | 0.4 | 0.1 | Favorable |
| Example 5 | 0.06 | 0.09 | 2.8 | 68 | 56 | 265 | 167 | 63% | 0.3 | 0.1 | Favorable |
| Example 6 | 0.07 | 0.08 | 2.6 | 65 | 40 | 305 | 195 | 74% | 0.4 | 0.1 | Favorable |
| Comparative Example 1 | 0.05 | 1.1 | 4.8 | 71 | 66 | 253 | 83 | 32% | 1.5 | 0.2 | Separated |
| Comparative Example 2 | 0.05 | 0.8 | 3.1 | 59 | 55 | 260 | 73 | 28% | 0.3 | 0.1 | Separated |
| Comparative Example 3 | 0.07 | 0.85 | 3.2 | 58 | 58 | 265 | 60 | 23% | 0.3 | 0.1 | Separated |

The retention rate of power-generating efficiency of the photovoltaic modules obtained in Examples 1 to 5 after exposure to a hot humid condition of 85°C and 85% for 1000 hours was found to be favorable at 95% or more. In addition, the photovoltaic modules in Comparative Examples showed deterioration in power-generating efficiency.
As for the adhesion state of terminal box, the adhesion of the terminal boxes of the photovoltaic modules obtained in Examples 1 to 5 were favorable and the terminal boxes were not separated, but the terminal boxes of Comparative Examples 1 to 3 were separated.
Further,afterthe environmentaltest,the backsheetswere subjected to an acceleration test in a pressure cooker tester at 120°C, 85%, and 1.6 atmospheres, and the breaking strengths thereof before and after the test were measured for comparison. The hydrolytic efficiency test for 72 hours under the condition above is an acceleration test corresponding to the condition at 85°C and 85% for 2, 000 hours ormore, as confirmed by examination of deterioration in breaking strength of a common industrial PET. As a result, there was a difference of twice or more when the retention rates of the breaking strength of Comparative Examples and Example are compared, and thus, it was possible to provide high-durability photovoltaic backsheets.
As for the shrinkage rate, the photovoltaic backsheet prepared by using a heat-shrunk hydrolysis-resistant film had a favorable shrinkage rate of about 0.3%, which was significantly smaller than that of the sheets without heat shrinkage treatment obtained in Comparative Example 1. In addition, low shrinkage rate also lead to improvement in appearance of the back side of the photovoltaic module after production.
In Comparative Example 1, a vacuum laminator was used for preparation of the photovoltaic module, which lead to decrease in the intercellular distance under the influence of the backsheet unfavorable in shrinkage rate and consequently to protrusion of the lead wire and thus deterioration in appearance of the back side of the photovoltaic module. Other photovoltaic modules, which had favorable shrinkage rate, showed not abnormality in appearance after vacuum lamination.

## Claims

1. A backsheet for photovoltaic module comprising a hydrolysis-resistant film and a resin film laminated on the hydrolysis-resistant film,
**characterized in that** the hydrolysis-resistant film is made of a polyester resin having a carboxy end-group content of 15 equivalent/ton or less, and the resin film is made of a polypropylene resin.

2. The backsheet forphotovoltaicmodule according to claim 1, further comprising a gas barrier film having a base film and a gas-barrier layer formed on at least one side of the base film, between the hydrolysis-resistant film and the resin film.

3. The backsheet forphotovoltaicmodule according to claim 2, further comprising two or more of the gas barrier films between the hydrolysis-resistant film and the resin film.

4. The backsheet for photovoltaic module according to any one of claims 1 to 3, **characterized in that** an intrinsic viscosity of the polyester resin is 0.8 dl/g or more.

5. A backsheet for photovoltaic module, comprising:
a first hydrolysis-resistant film,
a first gas barrier film having a first base film and a first gas-barrier layer formed thereon,
a resin film,
a second gas barrier film having a second base film and a second gas-barrier layer formed thereon, and
a second hydrolysis-resistant film that are laminated in this order,
**characterized in that** at least one of the first hydrolysis-resistant film and the second hydrolysis-resistant film is made of a polyester resin having a carboxy end-group content of 15 equivalent/ton or less, and the resin film is made of a polypropylene resin.

6. Thebacksheet forphotovoltaicmodule accordingto claim 5, **characterized in that** an intrinsic viscosity of the polyester resin is 0.8 dl/g or more.

7. The backsheet for photovoltaic module according to any one of claims 1 to 6, **characterized in that** a heat shrinkage rate thereof at 150°C for 30 minutes is 1.0% or less.

8. A back side laminate for photovoltaic module, comprising the backsheet for photovoltaic module according to any one of claims 1 to 4 and an encapsulant for photovoltaic module laminated on the resin film of the backsheet for photovoltaic module.

9. The backsidelaminatefor photovoltaic module according to claim 8, **characterized in that** the encapsulant for photovoltaicmodule contains a copolymer of apolyolefin compound and an ethylenically unsaturated silane compound.

10. A photovoltaic module comprising
a photovoltaic device,
a front encapsulant layer and a backside encapsulant layer sandwiching the photovoltaic device,
a frontside transparent substrate laminated on the front encapsulant layer, and
a backsheet laminated on the backside encapsulant layer, **characterized in that** the backsheet is the backsheet for photovoltaic module according to any one of claims 1 to 7.

11. The photovoltaic module according to claim 10, **characterized in that** a terminal box is installed on the backsheet.

12. The photovoltaic module according to claim 11, **characterized in that** the terminal box is bonded to the hydrolysis-resistant film constituting the backsheet with a silicone-based adhesive agent.
